(19) Europäisches Patentamt
European Patent Office
Office européen des brevets

(11) **EP 2 837 489 B1**

(12) **EUROPEAN PATENT SPECIFICATION**

(45) Date of publication and mention of the grant of the patent:
**25.10.2017  Bulletin 2017/43**

(51) Int Cl.:
***B29C 55/02*** *(2006.01)*  ***G02B 5/30*** *(2006.01)*

(21) Application number: **14178259.9**

(22) Date of filing: **24.07.2014**

(54) **Polarizing film, optically functional film laminate including polarizing film, production method for optical film laminate including polarizing film, and organic EL display device having polarizing film**

Polarisationsfolie, optisch funktionales Filmlaminat mit Polarisationsfolie, Verfahren zur Herstellung von optischem Filmlaminat mit Polarisationsfolie und organische EL-Anzeigevorrichtung mit Polarisationsfolie

Film de polarisation, stratifié de film fonctionnel optique incluant un film de polarisation, procédé de production d'un stratifié de film optique comprenant un film de polarisation et dispositif d'affichage électroluminescent organique ayant un film de polarisation

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **12.08.2013   JP 2013167728**

(43) Date of publication of application:
**18.02.2015  Bulletin 2015/08**

(73) Proprietor: **Nitto Denko Corporation**
**Ibaraki-shi, Osaka 567-8680 (JP)**

(72) Inventors:
• **Kitagawa, Takeharu**
**Ibaraki-shi, Osaka 567-8680 (JP)**

• **Goto, Shusaku**
**Ibaraki-shi, Osaka 567-8680 (JP)**

(74) Representative: **Gill Jennings & Every LLP**
**The Broadgate Tower**
**20 Primrose Street**
**London EC2A 2ES (GB)**

(56) References cited:
**EP-A2- 2 426 523**        **WO-A1-2012/056717**
**KR-A- 20100 129 509**   **US-A1- 2005 057 706**
**US-A1- 2013 160 938**

**Description**

TECHNICAL FIELD

The present invention relates to a polarizing film, an optically functional film laminate including the polarizing film, a production method for an optical film laminate including the polarizing film, and an organic EL display device having the polarizing film. In particular, the present invention relates to a thinned and high-transmittance polarizing film comprised of a polyvinyl alcohol-based resin containing molecularly-oriented iodine, an optically functional film laminate including the polarizing film, a production method for an optical film laminate including the polarizing film, and an organic EL display device having the polarizing film.

BACKGROUND ART

Generally, an organic EL display device has a light emitter (organic EL light-emitter) comprising a transparent electrode, an organic light-emitting layer and a metal electrode which are laminated on a transparent substrate in this order. In this regard, it is desirable to form the organic light-emitting layer as an extremely thin film having a thickness, for example, of about 10 nm. This is intended to allow light to be almost completely transmitted through the organic light-emitting layer, as with the transparent electrode. In this case, outside light entering through a surface of the transparent electrode is transmitted through the transparent electrode and the organic light-emitting layer, and reflected by the metal electrode, whereafter the reflected light exits to the outside through the surface of the transparent electrode. Thus, particularly in a black state, i.e., a non-luminous state, a display surface of the organic EL device looks like a minor surface when viewed from the outside.

Therefore, as means to prevent reflection on the metal electrode, there has been proposed a technique of using a polarizing film in combination with a retardation plate such as a 1/4 wavelength retardation plate. Specifically, when light enters from the outside, a linearly-polarized component of the entering light perpendicular to a transmission axis direction of the polarizing film is absorbed by the polarizing film, whereas a linearly-polarized component of the entering light parallel to the transmission axis direction of the polarizing film is transmitted through the polarizing film. An angle between the transmission axis direction of the polarizing film and a slow axis direction of a 1/4 wavelength retardation plate is set to 45 degrees, so that the 1/4 wavelength retardation plate functions to convert the linearly-polarized light transmitted through the polarizing film into circularly-polarized light. Then, the resulting circularly-polarized light is reflected by the metal electrode, and the reflected light re-enters the polarizing film through the 1/4 wavelength retardation plate. The light is controlled to re-enter the polarizing film at an angle perpendicular to the transmission axis direction of the polarizing film, for example, by adjusting a distance between the metal electrode and the 1/4 wavelength retardation plate, and/or a thickness of the 1/4 wavelength retardation plate. Thus, the linearly-polarized component of the entering light parallel to the transmission axis direction of the polarizing film is also absorbed by the polarizing film, so that it becomes possible to almost fully eliminate surface reflection in the organic EL display device.

As the polarizing film, it is common to use a polarizing film which comprises a polyvinyl alcohol-based resin (hereinafter referred to as "PVA-based resin") layer obtained by subjecting a single layer body, i.e., non-laminate, made of a PVA-based resin and formed in a film shape, to dyeing and stretching to thereby cause a dichroic material to be adsorbed to the PVA-based resin in a molecularly-oriented state. The polarizing film obtainable by the above conventional method using a film-shaped PVA-based resin non-laminate has a thickness in the range of about 15 to 35 $\mu$m. This conventional method is capable of obtaining a polarizing film having optical properties including a single transmittance of 42% or more and a polarization degree of 99.95% or more. Currently, polarizing films produced by the conventional method are used in optical display devices for televisions, mobile phones, PDAs and others.

In this connection, a PVA-based resin is hydrophilic and highly hygroscopic, so that a polarizing film produced using the PVA-based resin is sensitive to changes in temperature and humidity, and more likely to expand and contract due to changes in surrounding environments and thus undergo crack formation. Moreover, the expansion and contraction caused by environmental changes during use will produce stress in an adjacent member to which the polarizing film is bonded, thereby leading to deformation, such as warp, in the adjacent member.

Thus, in order to suppress such expansion and contraction of a polarizing film to thereby reduce influences of changes in temperature and humidity, a polarizing film for use in optical display devices for televisions, mobile phones, PDAs and others has been typically used in the form of a laminate in which a 40 to 80 $\mu$m-thick TAC (triacetylcellulose-based) film is laminated onto each of opposite surfaces of the polarizing film to serve as a protection film. However, even in such a structure, expansion and contraction forces of the polarizing film are still at a non-ignorable level, i.e., it is difficult to completely suppress influences on expansion and contraction of the polarizing film, and a certain level of expansion and contraction will inescapably occur in the optically functional film laminate including the polarizing film. When expansion or contraction occurs in such a polarizing film-including optically functional film laminate, stress arising from the expansion or contraction thereof will cause deformation, such as warp, in an adjacent member. This deformation, even if it is small, leads to the occurrence of display unevenness in a display device. Thus, as means to suppress the occurrence of display unevenness, it is necessary to make design considerations, for example, to carefully select a material for each member to be used in the polarizing film-including optically functional film laminate. Further, contraction stress of the polarizing film can cause peel-off of the optically functional film laminate from a display panel. Thus, a pressure sensitive-adhesive having high adhesion force is required to bond the optically functional film laminate to the display panel. However, the use of such a pressure sensitive-adhesive with high adhesion force gives rise to a problem that it becomes difficult to perform reworking which is an operation of, when the presence of an optical defect is found in a polarizing film of an optically functional film laminate laminated to a display panel by a subsequent inspection, peeling the optically functional film laminate from the display panel and laminating another optically functional film laminate to the display panel. In a liquid crystal display device where a polarizing film-including optically functional film laminate disposed on each of opposite surfaces of a liquid crystal display panel, contraction stresses of two polarizing films of the optically functional film laminates on the opposite surfaces of the liquid crystal display panel cancel out each other to thereby somewhat ease the problem of causing deformation, such as warp, in an adjacent member. On the other hand, in an organic EL display device using an organic EL display panel, the problem becomes particularly prominent, because a polarizing film-including optically functional film laminate is disposed on only one of opposite surfaces of the display panel. In addition to display unevenness and difficulty in reworking, the organic EL display device further involves a problem that a sealing material for the display panel is destroyed due to the warp of the display panel, and an organic light-emitting layer is degraded due to humidity. These are technical problems in a polarizing film produced by the conventional method using a film-shaped PVA-based resin non-laminate.

In view of the above problems, there is a need for a polarizing film reduced in thickness and thus expansion and contraction forces. However, the conventional polarizing film production method using a film-shaped PVA-based resin non-laminate is incapable of achieving a satisfactory level of thickness reduction. That is, the conventional method using a film-shaped PVA-based resin non-laminate is incapable of producing a polarizing film having a thickness of 10 $\mu$m or less. The reason is that, in the polarizing film production method using a film-shaped PVA-based resin non-laminate, when a thickness of the PVA-based resin non-laminate is excessively reduced, the PVA-based resin non-laminate is likely to undergo dissolution and/or breaking in a dyeing step and/or a stretching step, resulting in failing to stably form a polarizing film with a uniform thickness.

In order to cope with this problem, there has been proposed a method of producing a significantly thin polarizing film as compared to a polarizing film obtainable by the conventional method, wherein the production method comprises: applying and forming a PVA-based resin layer onto a thermoplastic resin substrate; and subjecting the PVA-based resin layer formed on the resin substrate to stretching and dyeing, together with the resin substrate. This polarizing film production method using a thermoplastic resin substrate is noteworthy in that it makes it possible to produce a polarizing film more uniformly than the polarizing film production method using a film-shaped PVA-based resin non-laminate.

For example, JP 4279944B (Patent Document 1) discloses a polarizing plate production method which comprises: forming a PVA-based resin layer having a thickness of 6 to 30$\mu$m on one of opposite surfaces of a thermoplastic resin film by a coating process; stretching the PVA-based resin layer at a stretching ratio of 2 to 5 times in such a manner as to allow the PVA-based resin layer to become a transparent coating element layer to thereby form a composite film consisting of the thermoplastic resin film and the transparent coating element layer; then laminating an optical transparent resin film layer to one surface of the two-layered composite film on the side of the transparent coating element layer, through an adhesive; then peeling and removing the thermoplastic resin film; and subjecting the transparent coating element layer to dyeing and dye fixing to form a polarizing element layer. A polarizing plate obtainable by this method has a two-layer structure consisting of the optically transparent resin film layer and the polarizing element layer. According to the description of the Patent Document 1, the polarizing element has a thickness of 2 to 4 $\mu$m.

The method disclosed in the Patent Document 1 is configured to perform stretching under elevating temperature by a uniaxial stretching process, wherein the stretching ratio is restricted to the range of 2.0 to 5.0 times. As for the reason why the stretching ratio is restricted to 5.0 times or less in the method disclosed in the Patent Document 1, the Patent Document 1 explains that it is because stretching at a high stretching ratio of greater than 5.0 times makes it extremely difficult to maintain stable production. Thus, when the stretching ratio is 5.0 times or less but close to 4.0 to 5.0 times, it would be difficult to ensure stable production. Further, regarding an ambient temperature during stretching, the Patent Document 1 makes mention that it is specifically set to: 55°C for the case where ethylene-vinyl acetate copolymer is used as the thermoplastic resin film; 60°C for the case where non-stretched polypropylene is used as the thermoplastic resin film; and 70°C for the case where non-stretched nylon is used as the thermoplastic resin film. The method disclosed in the Patent Document 1 employs a uniaxial in-air stretching process at an elevated temperature. Further, as described in the Patent Document 1, the stretching ratio is restricted to 5.0 times or less. Thus, this method has difficulty in stably producing a polarizing film which has an extremely small thickness of 2 to 4 $\mu$m and satisfies desired optical properties for allowing it to become usable for organic EL display devices. In other words, a polarizing film obtainable by this method with an extremely small thickness of 2 to 4 $\mu$m cannot satisfy desired optical properties of a polarizing film usable for organic EL display devices.

The method comprising forming a PVA-based resin layer on a thermoplastic resin substrate by a coating process and subjecting the PVA-based resin layer to stretching, together with the substrate to form a polarizing film is also disclosed in JP 2001-343521A (Patent Document 2) and JP 2003-043257A (Patent Document 3). The methods disclosed in the Patent Documents 2 and 3 are configured to subject a laminate comprising a thermoplastic resin substrate and a PVA-based resin layer applied on the substrate to uniaxial stretching at a temperature of 70 to 120°C for the case where the substrate is made of a non-crystallizable polyester resin. Then, the PVA-based resin layer molecularly oriented by the stretching is subjected to dyeing to adsorb a dichroic material thereto. The Patent Document 2 makes mention that the uniaxial stretching may be longitudinal uniaxial stretching or may be transverse uniaxial stretching. On the other hand the Patent Document 3 describes a technique of performing transverse uniaxial stretching, and, during or after the transverse uniaxial stretching, causing a length in a direction perpendicular to a stretching direction to contract by a specific amount. In both of the Patent Documents 2 and 3, as for stretching ratio, they make mention that it is typically set to about 4.0 to 8.0 times. Further, as for a thickness of an obtainable polarizing film, they make mention of a value of 1 to 1.6 $\mu$m.

The Patent Documents 2 and 3 make mention that the stretching ratio is typically in the range of 4.0 to 8.0 times. However, a stretching process employed in the Patent Documents 2 and 3 is elevated-temperature in-air stretching. Thus, for example, when the stretching ratio is increased beyond 5.0 times, this stretching process makes it extremely difficult to maintain stable production, as described in the Patent Document 1. None of the Patent Documents 2 and 3 describes a particular technique for achieving a stretching ratio of greater than 5.0 times by the elevated-temperature in-air stretching process. In fact, when reviewing Examples described in the Patent Documents 2 and 3, only a stretching ratio of 5.0 times is described in the Patent Document 2, and a stretching ratio of 4.5 times is described in the Patent Document 3. Through check experiments on the methods disclosed in the Patent Documents 2 and 3, the inventors of the present invention have ascertained that the methods disclosed therein are incapable of performing stretching at a stretching ratio of greater than 5.0 times, and stably performing stretching at a stretching ratio of 4 to 5 times. Therefore, it should be understood that each of the Patent Documents 2 and 3 describes only stretching to be performed at a stretching ratio of 5.0 times or less, and, when the stretching ratio is 5.0 or less but in the range of 4.0 to 5.0, the method has difficulty in maintaining stable production. Thus, as with the Patent Document 1, in the methods disclosed in the Patent Documents 2 and 3, the stretching ratio is restricted to 5.0 times or less. Thus, an obtainable extremely thin polarizing film is not enough to satisfy desired optical properties of a polarizing film usable for organic EL display devices, or it is difficult to stably produce an extremely thin polarizing film satisfying desired optical characteristics for allowing it to become usable for organic EL display devices.

USP 4,659,523B (Patent Document 4) discloses a polarizing film production method which comprises subjecting a PVA-based resin layer coated on a polyester film to uniaxial stretching, together with the polyester film. This method disclosed in the Patent Document 4 is intended to form the polyester film serving as a substrate of the PVA-based resin layer in such a manner as to have optical properties allowing the polyester film to be used together with a polarizing film, but it is not intended to produce a polarizing film comprising a PVA-based resin layer and having a small thickness and excellent optical properties. That is, the method disclosed in the Patent Document 4 is no more than a technique of improving optical properties of a polyester resin film to be stretched together with a PVA-based resin layer to be formed as a polarizing film. A polarizer material production method having the same object is also disclosed in JP 08-012296B (Patent Document 5).

However, the method which comprises: forming a PVA-based resin layer on a thermoplastic resin substrate by a coating process; and subjecting the PVA-based resin layer to stretching, together with the thermoplastic resin substrate to produce a polarizing film, as disclosed in the Patent Documents 1 to 5, is incapable of stably producing a polarizing film which has an extremely small thickness of 10 $\mu$m or less, and exhibiting a high single transmittance and a high polarization degree.

JP 4691205B (Patent Document 6) discloses a polarizing film improved in view of the above problems to have a thickness of 10 $\mu$m or less and exhibit an enhanced single transmittance and polarization degree. A polarizing film production method disclosed in the Patent Document 6 is configured to subject a non-crystallizable thermoplastic resin substrate and a PVA-based resin layer applied on the substrate to first-stage in-air stretching and second-stage in-boric-acid-solution stretching, together, thereby making it possible to stably form a thinned polarizing film having a thickness of 10 $\mu$m or less.

LIST OF PRIOR ART DOCUMENTS

[PATENT DOCUMENTS]

    Patent Document 1: JP 4279944B

Patent Document 2: JP 2001-343521 A
Patent Document 3: JP 2003-043257A
Patent Document 4: USP 4,659,523A
Patent Document 5: JP 08-012296B
Patent Document 6: JP 4691205B

[NON-PATENT DOCUMENTS]

Non-Patent Document 1: K. Matsuhiro, "Xpol and its Application to 3D-TV", "EKISHO", Vol. 14, No. 4, 2010, pp 219-232

SUMMARY OF THE INVENTION

[TECHNICAL PROBLEM]

Recently, there has been an increasing need for an organic EL display device to further reduce electrical consumption to save electricity, and extend a continuously usable time period of the device. In order to reduce electrical consumption, it is necessary to reduce an organic EL emission intensity. Further, in order to maintain sufficient viewability at lower emission intensity, it is necessary to improve a transmittance of a polarizing film used as a display surface of an organic EL display device. However, in a thinned polarizing film prepared by a conventional technique, an increase in single transmittance undesirably causes deterioration in durability. For example, when a thinned and high-transmittance polarizing film prepared by a conventional technique is subjected to a durability test, an appearance defect, such as color unevenness, occurs.

The problem of deterioration in durability first became prominent when a thinned and high-single transmittance polarizing film had been prepared. A causal factor of the problem clarified by inventors' speculations will be described below.

Generally, a polarizing film is prepared by subjecting a PVA resin to a dyeing step to cause a dichroic material to be adsorbed to the PVA resin, and subjecting the PVA resin with the adsorbed dichroic material to a stretching step to cause the dichroic material to be molecularly oriented. In recent years, iodine has been commonly used as the dichroic material. In the dyeing step, the PVA resin is immersed in an aqueous iodine solution. In this regard, however, iodine molecules ($I_2$) are not soluble in water by themselves. Therefore, iodine is dissolved in water together with potassium iodide (KI) to prepare an aqueous iodine-potassium iodide solution. In the aqueous iodine-potassium iodide solution, in addition to potassium ions ($K^+$) and iodine ions ($I^-$), there are polyiodide ions ($I_3^-$ and $I_5^-$) each formed by coupling between iodine ions and an iodine molecule. In the dyeing step, iodine ions and polyiodide ions are adsorbed to and impregnated into the PVA resin. Then, in the subsequent stretching step, the PVA resin is stretched and molecularly oriented, and the polyiodide ions are also oriented in a stretching direction. Depending on an angle of a polarization direction of entering light with respect to an orientation direction of the oriented polyiodide ions, the oriented polyiodide ions provide different transmittances, so that the dyed and stretched PVA resin functions as a polarizing film.

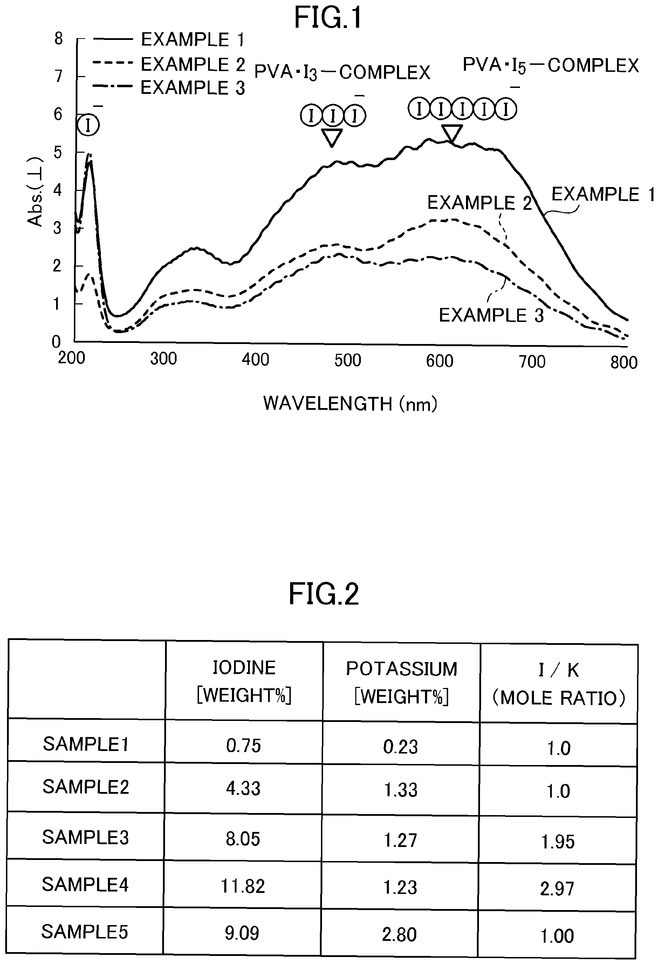

FIG. 1 illustrates some examples of an absorption spectrum of a PVA resin subjected to dyeing using an aqueous iodine solution and stretching. Polyiodide ions are adsorbed to and impregnated into a PVA resin to form PVA-iodine complexes (PVA · $I_3^-$ and PVA · $I_5^-$). An iodine ion ($I^-$) has an absorption peak around 230 nm. A triiodide ion in a complexed state with PVA (PVA · $I_3^-$) has an absorption peak around 470 nm. A pentaiodide ion in a complexed state with PVA (PVA · $I_5^-$) has an absorption peak around 600 nm. A wavelength of light to be absorbed varies depending on a type of PVA-iodine complex, so that the polyiodide ion has a broad absorption peak. As can be seen from FIG. 1, PVA-iodine complexes absorb visible light. On the other hand, an iodine ion has a peak around 230 nm, i.e., does not absorb visible light. Thus, an amount of polyiodide ions complexed with PVA exerts an influence on performance of a polarizing film in a display device such as an organic EL display device.

It is believed that iodine exists in a PVA resin in accordance with the following two chemical equilibrium equations:

(Formula 1)

$$I_5^- + I^- \underset{H_2O}{\overset{\Delta}{\rightleftharpoons}} 2I_3^-$$

(Formula 2)

$$I_3^- \xrightarrow[H_2O]{\Delta} I^- + I_2$$

As represented by Formula 1, a pentaiodide ion is subjected to thermal reaction with an iodine ion, and decomposed into two triiodide ions. Further, as can be seen from Formula 2, a triiodide ion is thermally decomposed into an iodine ion and an iodine molecule. On the other hand, in the presence of water such as a high-humidity environment, a reverse reaction with respect to the above thermal decomposition reaction occurs. However, except for usage in aqueous solution and a humidified environment, for example, in a normal usage state in an organic EL display device, the thermal decomposition reaction would be dominant, because of a small amount of water in the PVA resin. Thus, a polyiodide ion is decomposed by the thermal decomposition reaction, thereby causing degradation of the polarizing film.

In order to obtain sufficient polarization performance even when a thickness of a polarizing film is reduced (e.g., to 7 $\mu$m or less), it is necessary to maintain an amount of iodine in PVA, so that it becomes necessary to increase an iodine density in the PVA resin. The increased iodine density leads to an increase in speed of the reactions presented by Formulas 1 and 2, i.e., an acceleration of the polyiodide decomposition reaction, causing deterioration in durability. Therefore, along with a reduction in thickness of the polarizing film, durability of the polarizing film would become more deteriorated.

On the other hand, in order to increase the transmittance, it is necessary to reduce an amount of complex of the polyiodide ion and PVA (polyiodide ion complex) (the number of cross-linking nodes), under a condition that a thickness of a polarizing film is kept constant. It is assumed that, when the number of cross-linking nodes is reduced, a stability of the polyiodide ion is undesirably deteriorated, and therefore durability of the polyiodide ion against thermal decomposition is deteriorated.

That is, both smaller thickness and higher transmittance becomes a factor causing deterioration in durability, so that a thinned and high-transmittance polarizing film obtained by a conventional technique would have poor durability.

It is an object of the present invention to provide a polarizing film having a small thickness but exhibiting a high transmittance and a high durability. It is also an object of the present invention to provide an optically functional film laminate including the polarizing film, a production method for an optical film laminate including the polarizing film, and an organic EL display device having the polarizing film.

[SOLUTION TO THE TECHNICAL PROBLEM]

As a result of researches based on recognition of the above problems and clarification of causal factors, the inventors found that durability is improved by increasing a mole ratio (I/K) of elemental iodine to elemental potassium contained in a polarizing film, and have reached the present invention.

The reason why durability is improved by increasing a mole ratio (I/K) of iodine (I) to potassium (K), assumed by the inventors, will be described below.

As can be seen from Formulas 1 and 2, the thermal decomposition reaction proceeds in such a manner that a pentaiodide ion is subjected to collision with an iodine ion and thereby decomposed into two triiodide ions, and then the triiodide ion is decomposed into an iodine ion and an iodine molecule. Thus, thermal decomposition of a pentaiodide ion can be suppressed by reducing an amount of iodine ions to make the iodine ion less likely to collide with the pentaiodide ion. Further, the suppression of the thermal decomposition of the pentaiodide ion leads to a reduction in amount of triiodide ions, so that the decomposition of the triiodide ion represented by Formula 2 is also suppressed. Thus, it is expected that a reduction in iodine ion concentration makes it possible to suppress thermal decomposition of polyiodide ion to thereby improve durability.

In order to reduce the iodine ion concentration, it is necessary to reduce a potassium iodide concentration. This is because an amount of iodine ions becomes smaller along with a reduction in amount of potassium ions. Further, a reduction in amount of potassium iodide under a condition that an amount of elemental iodine is kept constant means that an amount of iodine ions is relatively small, and, on the other hand, an amount of iodine molecules is relatively large, so that it may be said that the iodine ions are bound to the iodine molecules, and thus there are a larger number of polyiodide ions. In other words, under the condition that an amount of elemental iodine is kept constant, along with a reduction in potassium ions, an amount of polyiodide ions becomes larger, and an amount of iodine ions becomes smaller, to allow positive and negative charges to balance out. Thus, it may be said that the thermal decomposition of polyiodide ion can be suppressed by relatively increasing an amount of elemental iodine contained in the PVA resin with respect to an amount of elemental potassium.

Based on the above speculations, the inventors propose a polarizing film as disclosed in claim 1. Preferably, in the polarizing film of the present invention, an elemental iodine concentration in the polarizing film is 6 weight% or less.

Preferably, in the polarizing film of the present invention, the mole ratio (I/K) of elemental iodine (I) to elemental potassium (K) contained in the polarizing film is 3.0 or less.

In the polarizing film of the present invention, the single transmittance of the polarizing film may be 44.3% or more, and the thickness of the polarizing film may be 5 $\mu$m or less.

Further, according to another aspect of the present invention, there is provided an optically functional film laminate which comprises the above polarizing film; an optically functional film provided on the side of one of opposite surfaces of the polarizing film; and a peeling film releasably provided on the side of the other surface through a pressure-sensitive adhesive layer. In this case, the optically functional film is preferably composed of a transparent optically functional film, such as a TAC (triacetyl cellulose-based) film or an acrylic-based film. As a material for bonding or adhesively bonding a layer, it is possible to appropriately select and use a material comprising, as a base polymer, a polymer, such as acrylic-based polymer, silicone-based polymer, polyester, polyurethane, polyamide, polyether, fluorine or rubber-based polymer, isocyanate-based polymer, polyvinyl alcohol-based polymer, gelatin-based polymer, vinyl or latex-based polymer, or waterborne polyester.

According to yet another aspect of the present invention, there is provided an optically functional film laminate which comprises: the above polarizing film; a first optically functional film provided on the side of one of opposite surfaces of the polarizing film; and a second optically functional film provided on the side of the other surface, wherein the optically functional film laminate further comprises a peeling film releasably provided on one of opposite surface thereof through a pressure-sensitive adhesive layer.

According to still another aspect of the present invention, there is provided an optically functional film laminate which comprises: the above polarizing film; a protective layer provided on the side of one of opposite surfaces of the polarizing film; and a retardation layer provided on the side of the other surface and configured to generate circularly-polarized light in cooperation with the polarizing film, wherein the optically functional film laminate further comprises a peeling film releasably provided on one surface thereof through a pressure-sensitive adhesive layer. In this case, it is preferable that the protective layer is composed of a TAC (triacetyl cellulose-based) film, and the retardation layer is composed of a biaxial retardation film having a three-dimensional refraction index satisfying the following relationship: nx > nz > ny.

According to yet still another aspect of the present invention, there is provided an organic EL display device which comprises an optically functional film laminate which includes: the above polarizing film; a first retardation layer on the side of one of opposite surfaces of the polarizing film; and a protective layer of a transparent resin material on the side of the other surface, wherein the optically functional film laminate is provided on one surface of an organic EL display panel through a pressure-sensitive adhesive layer lying on the side of the first retardation layer, and wherein the optically functional film laminate is operable to generate circularly-polarized light so as to prevent light entering from a viewing side of the polarizing film from exiting toward the viewing side after internal reflection.

According to another further aspect of the present invention, there is provided a method of producing an optical film laminate in which a polarizing film comprised of a polyvinyl alcohol-based resin having molecularly-oriented iodine is formed on a non-crystallizable ester-based thermoplastic resin substrate in the form of a continuous web, wherein the polarizing film has a thickness of 7 $\mu$m or less, and exhibits a single transmittance of 44.0% or more. The method comprises: a first stretching step of subjecting a laminate including the non-crystallizable ester-based thermoplastic resin substrate and a polyvinyl alcohol-based resin layer formed on the non-crystallizable ester-based thermoplastic resin substrate, to in-air stretching to form a stretched laminate comprising a stretched intermediate product consisting of a molecularly-oriented polyvinyl alcohol-based resin layer; a first insolubilization step of subjecting the stretched intermediate product comprised in the stretched laminate to insolubilization to form an insolubilized stretched laminate; a dyeing step of adsorbing iodine to the insolubilized stretched laminate to form a dyed laminate; a second insolubilization step of subjecting the stretched intermediate product comprised in the dyed laminate to insolubilization to form an insolubilized dyed laminate;

a second stretching step of subjecting the insolubilized dyed laminate to stretching in an aqueous boric acid solution to form an optical film laminate including a polarizing film comprised of a polyvinyl alcohol-based resin having molecularly-oriented iodine; and a cleaning step of cleaning the optical film laminate by an aqueous potassium iodide solution to allow a mole ratio (I/K) of elemental iodine (I) to elemental potassium (K) contained in the polarizing film to be 1.8 or more.

Preferably, in the method of the present invention, the first insolubilization step consists of a step of immersing the stretched laminate in an aqueous boric acid solution, and the second insolubilization step consists of a step of immersing the dyed laminate in an aqueous boric acid solution.

Preferably, in the method of the present invention, the second stretching step consists of a step of stretching the insolubilized dyed laminate in an aqueous boric acid solution containing boric acid in an amount of 6.5 weight parts or more and potassium iodide in an amount of 5 weight parts, with respect to 100 weight parts of water, to form an optical film laminate including a polarizing film comprised of a polyvinyl alcohol-based resin having molecularly-oriented iodine, and the cleaning step consists of a step of cleaning the optical film laminate by an aqueous potassium iodide solution containing potassium iodide in an amount of 0.5 to 2 weight parts with respect to 100 weight parts of water.

In the method of the present invention, the non-crystallizable thermoplastic resin substrate may be a non-crystallizable ester-based thermoplastic resin substrate. In this case, the non-crystallizable ester-based thermoplastic resin preferably consists of non-crystallizable polyethylene terephthalate including polyethylene terephthalate copolymerized with isophthalic acid, polyethylene terephthalate copolymerized with cyclohexanedimethanol or other copolymerized polyethylene terephthalate, wherein the non-crystallizable polyethylene terephthalate is set to have an orientation function of 0.10 or less, and subjected to elevated-temperature in-air stretching in-air stretching. Further, the non-crystallizable thermoplastic resin substrate is preferably made of a transparent resin.

As one embodiment, the method of the present invention may further comprise a step of applying a polyvinyl alcohol-based resin onto the non-crystallizable thermoplastic resin substrate and drying the applied polyvinyl alcohol-based resin to form a polyvinyl alcohol-based resin layer on the non-crystallizable thermoplastic resin substrate.

Preferably, the method of the present invention, the first stretching step is performed at a stretching ratio of 3.5 times or less. Further, the first stretching step is preferably performed at a stretching temperature equal to or greater than a glass transition temperature of the polyvinyl alcohol-based resin. A total stretching ratio for the stretched laminate and the dyed laminate in the first and second stretching steps is preferably set in the range of 5.0 to 6.5 times.

[EFFECT OF THE INVENTION]

The present invention can provide a polarizing film having a high durability while achieving a small thickness and a high transmittance.

BRIEF DESCRIPTION OF THE DRAWINGS

FIG. 1 is a graph indicative of some examples of an absorption spectrum of an iodine-dyed PVA resin.

FIG. 2 is a table presenting an iodine concentration, a potassium concentration and a mole ratio of elemental iodine to elemental potassium, in an aqueous iodine-potassium iodide solution for preparing a calibration curve.

FIG. 3 is a table presenting a detection result of elemental iodine and elemental potassium in an absorbance measurement, and a converted value from an intensity ratio to a mole ratio.

FIG. 4 is a graph indicative of one example of an absorption spectrum of elemental iodine measured by an X-ray fluorescence spectrometer.

FIG. 5 is a graph indicative of an iodine calibration curve.

FIG. 6 is a graph indicative of a potassium calibration curve.

FIG. 7 is a table presenting an evaluation result of inventive, comparative and reference examples.

FIG. 8 is a photograph indicative of an example of an appearance defect in a durability test.

FIG. 9 is a schematic diagram illustrating a process for producing an optical film laminate.

FIG. 10a is a sectional view illustrating one example of an organic EL display device according to a first embodiment of the present invention.

FIG. 10b is a sectional view illustrating another example of the organic EL display device according to the first embodiment of the present invention.

FIG. 10c is a sectional view illustrating yet another example of the organic EL display device according to the first embodiment of the present invention.

FIG. 10d is a sectional view illustrating still another example of the organic EL display device according to the first embodiment of the present invention.

FIG. 10e is a sectional view illustrating yet still another example of the organic EL display device according to the first embodiment of the present invention.

FIG. 10f is a sectional view illustrating another further example of the organic EL display device according to the first embodiment of the present invention.

FIG. 10g is a sectional view illustrating still a further example of the organic EL display device according to the first embodiment of the present invention.

FIG. 10h is a sectional view illustrating an additional example of the organic EL display device according to the first embodiment of the present invention.

FIG. 11 is a sectional view illustrating one example of an optical display device according to a second embodiment of the present invention.

FIG. 12a is a sectional view illustrating one example of an optical display device according to a third embodiment of the present invention.

FIG. 12b is a sectional view illustrating another example of an optical display device according to the third embodiment of the present invention.

DESCRIPTION OF EMBODIMENTS

Explanations about Inventive Examples 1 to 3 will be described below. For comparison and reference, Comparative Example and Reference Examples 1 and 2 will also be described.

[MEASUREMENT METHODS FOR PROPERTIES OF POLARIZING FILM]

Methods for determining respective properties of each polarizing film will be described below. Measurement items concerning properties of each polarizing film consist of thickness, transmittance, iodine concentration and content ratio of elemental iodine to elemental potassium. The following measurement method for each of the properties is one example, and any other suitable measurement method may be employed.

[Measurement of Thickness of Polarizing Film]

A thickness of each polarizing film was measured using a digital micrometer (KC-351C produced by Anritsu Corporation).

[Measurement of Transmittance of Polarizing Film]

The measurements of optical properties of each polarizing film were performed in a state in which a protective layer (acrylic-based film) was laminated to the polarizing film in order to facilitate handling of the polarizing film. The polarizing film with the protective layer laminated thereto was subjected to measurement of single transmittance, using a UV-visible spectrophotometer (V7100 produced by JASCO Corporation), and the measured single transmittance was determined as a transmittance of the polarizing film. As used here, the term "transmittance" is a Y value measured by the 2-degree visual field (C light source) of JIS Z8701 and corrected for spectral luminous efficacy. Absorption of the protective layer is negligibly small as compared to absorption of the polarizing film. Thus, a transmittance of the laminate was determined as a transmittance of the polarizing film.

[Measurement Method for Elemental Potassium Concentration and Mole Ratio of Elemental Iodine to Elemental Potassium]

The polarizing film with the protective layer laminated thereto was subjected to quantitative measurement of elemental iodine concentration, using a calibration curve method for fluorescent X-ray analysis. An X-ray fluorescence spectrometer (ZSX produced by Rigaku Corporation) was used as an analyzer. Neither elemental iodine nor elemental potassium is contained in the protective layer, so that there is no influence of the protective layer on the measurement result.

A value directly obtained by the X-ray fluorescence spectrometer is not a concentration of each element but an absorption intensity at a wavelength corresponding to each element. Thus, in order to obtain a concentration of elemental iodine or elemental potassium contained in each polarizing film, it is necessary to convert the measured absorption intensity value into an element concentration. As used in this specification, the terms "elemental iodine concentration" and "elemental potassium concentration" in each polarizing film mean, respectively, an elemental iodine concentration (weight%) and an elemental potassium concentration (weight%) on the basis of a weight of the polarizing film.

The calibration curve was prepared as follows.

1. Potassium iodide and iodine were dissolved in an aqueous PVA solution in respective known amounts to prepare a plurality of types of aqueous PVA solutions each containing iodine and potassium iodide in respective known concentrations. The aqueous PVA solutions were applied and dried to prepare a plurality of types of PVA film samples each containing potassium and iodine in respective element concentrations. An elemental iodine concentration, an elemental potassium concentration and an element ratio of iodine to potassium are presented in FIG. 2.

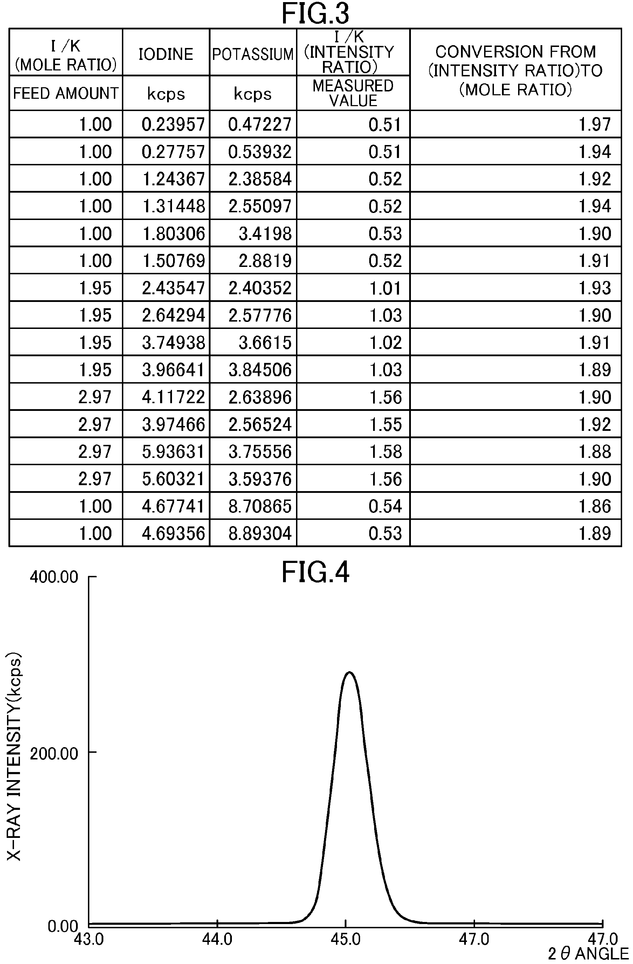

2. Each of the prepared PVA films was subjected to X-ray fluorescent spectrometric analysis using the X-ray fluorescence spectrometer to detect absorption intensities corresponding to elemental iodine and elemental potassium. A result of the detection is presented in FIG. 3. FIG. 4 indicates one example of an absorption spectrum of elemental iodine measured by the X-ray fluorescence spectrometer. The horizontal axis represents a diffraction angle of measurement light in a diffraction grating provided inside the X-ray fluorescence spectrometer, wherein the diffraction angle corresponds to a wavelength of the light. The vertical axis represents an absorption intensity (kcps). As indicated in FIG. 4, the absorption spectrum has a width. Thus, an absorption intensity of the dyed PVA film was determined based on a peak area.

3. The absorption intensity was divided by a thickness ($\mu$m) of the PVA film to obtain an absorption intensity per unit film thickness (kcps/$\mu$m).

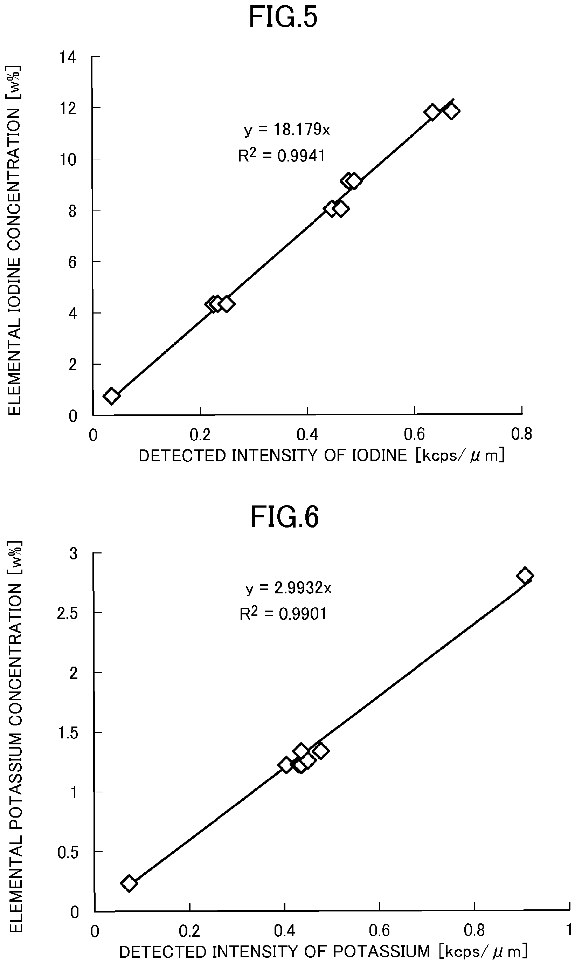

4. Then, based on the detection result presented in FIG. 3, a calibration curve was plotted on a coordinate system having a horizontal axis representing the detected intensity of iodine or potassium per unit film thickness (kcps/$\mu$m), and a vertical axis representing the concentration (weight%) of elemental iodine or elemental potassium contained in each PVA film used in the measurement. The prepared calibration curves are indicated, respectively, in FIG. 5 for iodine and FIG. 6 for potassium. A formula expressing the iodine calibration curve is presented as Formula 3, and a formula expressing the potassium calibration curve is presented as Formula 4.

(Formula 3)

(Elemental iodine concentration [weight%] = 18.2 × (detected intensity per unit film thickness) [kcps/$\mu$m]

(Formula 4)

(Elemental potassium concentration [weight%] = 2.99 × (detected intensity per unit film thickness) [kcps/$\mu$m]

5: A ratio of the detected intensity of iodine to the detected intensity of potassium was calculated. The elemental iodine concentration and the elemental potassium concentration are known, so that a mole ratio of elemental iodine to elemental potassium in each prepared PVA film can be computationally obtained. Thus, a formula for converting a ratio of an iodine absorption intensity to a potassium absorption intensity detected by measurement of each polarizing film, into a mole ratio of elemental iodine to elemental potassium contained in the polarizing film, can be obtained by calculating a conversion factor between the detected intensity ratio and the known mole ratio with respect to each of the plurality of samples, and averaging the calculated conversion factors. The average of the intensity ratio-to-mole ratio conversion factors in the plurality of samples is 1.91, and the conversion formula is expressed as Formula 5.

(Formula 5)

I/K (mole ratio) = I/K (intensity ratio) × 1.91

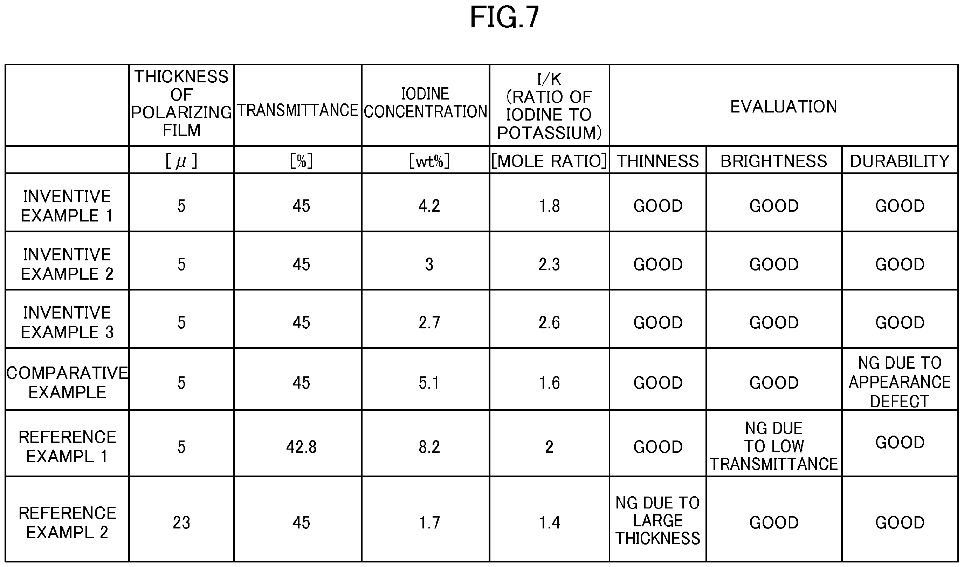

FIG. 7 presents properties of Inventive Examples 1 to 3, Comparative Example and Reference Examples 1 and 2. As can be seen from FIG. 7, all polarizing films of Inventive Examples 1 to 3 are a thin type having a thickness of 5 $\mu$m. In addition, all of the polarizing films of Inventive Examples 1 to 3 are a high-transmittance type exhibiting a transmittance of 45.0%. In all of the polarizing films of Inventive Examples 1 to 3, a mole ratio (I/K) of elemental iodine (I) to elemental potassium (K) contained in each polarizing film is 1.8 or more. Further, in all of the polarizing films of Inventive Examples 1 to 3, the mole ratio is 3.0 or less. This is because a pentaiodide ion concentration becomes higher along with an increase in the mole ratio, so that, if the mole ratio becomes greater than 3.0, an imbalance in absorption spectrum occurs, and thereby the polarizing film becomes blue-tinged. In all of the polarizing films of Inventive Examples 1 to 3, the elemental iodine concentration is set to 6 weight% or less to increase the transmittance.

As with Inventive Examples 1 to 3, Comparative Example for comparison to Inventive Examples has a thickness of 5 $\mu$m and exhibits a transmittance of 45.0%. On the other hand, an element content ratio of iodine to potassium is 1.6. A polarizing film of Reference Example 1 is a thin type having a thickness of 5 $\mu$m but a low-transmittance type having a transmittance of 42.8%. A polarizing film of Reference Example 2 can be deemed as a high-transmittance type having a transmittance of 45.0% but is a thick type having a thickness of 23 $\mu$m.

[EVALUATION OF DURABILITY]

Inventive Examples 1 to 3, Comparative Example and Reference Examples 1 and 2 were subjected to evaluation of durability in the following manner. The evaluation of durability was performed using a circularly-polarizing film formed by laminating a target polarizing film to be evaluated, and a 1/4 wavelength retardation film. The 1/4 wavelength retardation film was prepared by synthesizing a film material and subjecting the film material to film formation and stretching, in the following manner.

In order to synthesize a film material, 397.3 weight parts of isosorbide (produced by Roquette Freres, trade name: POLYSORB, hereinafter referred to as "ISB"), 960.1 weight parts of 9,9-bis [4- (2-hydroxyethoxy) phenyl] fluorene (produced by Osaka Gas Chemicals Co., Ltd., hereinafter referred to as "BHEPF"), 14.6 weight parts of polyethylene glycol having a number average molecular weight of 1000 (produced by Sanyo Chemical Industries, Ltd., hereinafter referred to as "PEG#1000"), 1065.1 weight parts of diphenyl carbonate (produced by Mitsubishi Chemical Corporation, hereinafter referred to as "DPC"), and 8.45 x $10^{-3}$ weight parts of magnesium acetate tetrahydrate serving as a catalyst, were put into a reactor container, and, as a first-stage reaction step, a temperature of a heating medium of the reactor container was set to 150°C to melt the raw materials in a nitrogen atmosphere, while stirring them as needed, by taking about 15 minutes. Then, an internal temperature of the reactor container was increased up to 220°C, and, immediately after reaching 220°C, an internal pressure of the reactor container was reduced from normal pressure to 13.3 kPa by taking 90 minutes. During the pressure reduction, the internal temperature was maintained at 220°C. Generated phenol was extracted and released to an outside of the reaction container. As a second-stage reaction step, after reaching 13.3 kPa, the internal temperature was increased up to 240°C by taking 15 minutes. During the temperature rise, the internal pressure was maintained at 13.3 kPa. After the internal temperature reaches 240°C, the internal pressure was reduced from 13.3 kPa to 200 Pa or less by taking 15 minutes. After reaching a given stirring torque, the reaction is terminated. Then, a resulting reaction product was pushed out into water, and subjected to pelletization to obtain a polycarbonate resin in which BHEPF / IBS / PEG#1000 = 44.5 mol% / 55.2 mol% / 0.3 mol%.

Then, as a film formation and stretching step, the obtained polycarbonate resin was subjected to vacuum-drying at 80°C for 5 hours, and a 95 $\mu$m-thick polycarbonate film was prepared using a film-forming apparatus equipped with a single-screw extruder (produced by Isuzu Kakoki Co, Ltd., screw diameter: 25 mm, cylinder preset temperature: 220°C), a T-die (width: 200 mm, preset temperature: 220°C), a chill roll (preset temperature: 120 to 130°C) and a winder. The prepared polycarbonate film was subjected to vacuum-drying at 100°C for 3 days to remove volatile components contained in the film, such as phenol. The film treated in this manner was subjected to uniaxial stretching at a stretching ratio of 1 x 2.0 times by using a batch-type biaxial stretching apparatus (produced by Bruckner Maschinenbau GmbH), at a stretching speed of 360 mm/min (stain rate: 300%/min), while adjusting a stretching temperature to allow $R_1$ (550) to fall within 130 $\pm$ 20 nm, to thereby obtaining a 1/4 wavelength retardation film. In this step, the stretching was performed without holding the film in a direction perpendicular to a stretching direction.

A circularly-polarizing film was prepared by arranging a surface of the target polarizing film and the 1/4 wavelength retardation film in such a manner that an angle between an absorption axis of the polarizing film and a slow axis of the 1/4 wavelength retardation film becomes 45 degrees. Regarding Reference Example 2, a laminate was prepared by laminating a saponified triacetylcellulose film (40 $\mu$m) to each of opposite sides of a polarizing film, and a circularly-polarizing film was prepared by laminating the 1/4 wavelength retardation film to the laminate. A PVA-based adhesive was used for the lamination between the polarizing film and the triacetylcellulose film.

Then, each of the circularly-polarizing films was cut into A4 size and laminated to a 0.7 $\mu$m-thick glass plate through an acrylic-based pressure-sensitive adhesive (20 $\mu$m) lying on the side of the 1/4 wavelength retardation film of the circularly-polarizing film. In advance of a durability test, no presence of an appearance defect in the circularly-polarizing film laminated to the glass plate was ascertained. After ascertaining no presence of an appearance defect, the circularly-polarizing film was stored in an oven at 85°C for 100 hours, and then a visual quality on reflected light at a surface of the circularly-polarizing film was checked. Specifically, the circularly-polarizing film laminated to the glass plate was placed on a reflective plate having a reflectance of 80% or more, while orienting the glass plate downwardly, and a visual quality was evaluated in this state.

[EVALUATION RESULT]

A result of the evaluation is presented in FIG. 7.

Further, in addition to durability, in terms of practical use, brightness and thinness were also evaluated on the basis of whether or not the polarizing film can be used in an organic EL display device.

As for durability, any polarizing film having no appearance defect such as color unevenness or line-like pattern during visual inspection after the above durability test was evaluated as "Good".

As for thinness, any polarizing film having a thickness of 7 $\mu$m or less, usable as a polarizing film for an organic EL display device, was evaluated as "Good".

As for brightness, any polarizing film having a transmittance of 44.0% or more was evaluated as "Good".

All of the polarizing films of Inventive Examples 1 to 3 have a small thickness of 5 $\mu$m, and exhibit a high transmittance of 45%. In addition, when they were subjected to the durability test after ascertaining no presence of an appearance defect, no appearance defect occurred in Inventive Examples 1 to 3 even after the durability test. Therefore, it can be said that each of the polarizing films of Inventive Examples 1 to 3 is a thinned and high-transmittance type with a high durability, and suitable as a polarizing film for use in, but not limited to, an organic EL display device.

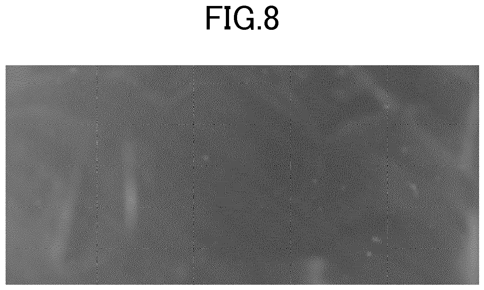

The polarizing film of Comparative Example has a small thickness of 5 $\mu$m and a high transmittance of 45%, as mentioned above. However, although no presence of an appearance defect in Comparative Example was ascertained in advance of the durability test, an appearance defect of line-like pattern extending obliquely from an upper side toward a lower right side of the polarizing film was ascertained after the durability test, as indicated in FIG. 8. In the polarizing film of Comparative Example, the mole ratio of elemental iodine to elemental potassium iodide is 1.6 which is less than those in Inventive Examples 1 to 3. On the other hand, in terms of the material of the polarizing film, and other properties such as thinness and transmittance, there is no substantial difference between Comparative Example and Inventive Examples 1 to 3. Thus, it can be said that, even in a thinned and high-transmittance polarizing film, a desired durability can be realized by increasing the ratio (I/K) of elemental iodine to elemental potassium contained in the polarizing film.

The polarizing film of Reference Example 1 exhibits a high durability but a low transmittance of 42.8%. Thus, in order to allow light transmitted through the polarizing film to have a certain level of intensity, it is necessary to enter light having a higher intensity. Therefore, in the case where the polarizing film of Reference Example 1 is used, for example, in an organic EL display device, it is necessary to generate entering light having a higher intensity, resulting in consumption of larger electricity. The polarizing film of Reference Example 2 also exhibits a high durability but has a large thickness of 23 $\mu$m. Thus, when the polarizing film of Reference Example 2 is used as a polarizing film for use, for example, in an organic EL display device, expansion and contraction thereof are likely to cause deformation, such as warp, in an adjacent member. From the above measurement results, it can be understood that, differently from the prior-art polarizing films, each of the polarizing films of Inventive Examples 1 to 3 has an advantageous effect of having a small thickness but exhibiting a high transmittance and a high durability.

[POLARIZING FILM PRODUCTION METHOD]

Production methods for Inventive Examples 1 to 3, Comparative Example and Reference Examples 1 and 2 will be described below. Before that, an outline of general material properties of a thermoplastic resin usable in producing a polarizing film for use in the present invention will be described.

Thermoplastic resins are roughly classified into two types: one which is in a state in which polymer molecules are orderly arranged; and the other which is in a state in which only a small portion of polymer molecules are orderly arranged. The former state is called "crystallized state", and the latter state is called "amorphous or non-crystallized state". Correspondingly, one type of thermoplastic resin having a property capable of being transformed from a non-crystallized state into a crystallized state depending on conditions is called "crystallizable resin", and the other type of thermoplastic resin which does not have such a property is called "non-crystallizable resin". On the other hand, regardless of whether a crystallizable resin or a non-crystallizable resin, a resin which is not in a crystallized state or has not been transformed into a crystallized state, is called "amorphous or non-crystalline resin". The term "amorphous or non-crystalline" will be used herein in distinction from the term "non-crystallizable" which means a property incapable of transformation into a crystallized state.

Examples of the crystallizable resin include olefin-based resins such as polyethylene (PE) and polypropylene (PP), and ester-based resins such as polyethylene terephthalate (PET) and polybutylene terephthalate (PBT). One feature of the crystallizable resin is that it has a property of being able to achieve orderly arrangement of polymer molecules, i.e., a progress in crystallization, by means of heating and/or stretching/molecular-orientation. Physical properties of a resin vary according to a degree of crystallization. On the other hand, even in crystallizable resins such as polypropylene (PP) and polyethylene terephthalate (PET), it is possible to suppress crystallization by inhibiting orderly arrangement of polymer molecules to be caused by heating or stretching/molecular-orientation. The crystallization-inhibited polypropylene (PP) and polyethylene terephthalate (PET) will hereinafter be referred to respectively as "non-crystallizable polypropylene" and "non-crystallizable polyethylene terephthalate", and referred to respectively and generically as "non-crystallizable olefin-based resin" and "non-crystallizable ester-based resin".

For example, as for polypropylene (PP), it is possible to produce a crystallization-inhibited non-crystallizable polypropylene (PP) by forming it into an atactic structure having no stereoscopic regularity. For example, as for polyethylene terephthalate (PET), it is possible to produce a crystallization-inhibited non-crystallizable polyethylene terephthalate (PET) by copolymerizing therewith isophthalic acid or a modifier group such as 1,4-cyclohexanedimethanol, as a polymerizing monomer, i.e., by copolymerizing therewith a molecule which inhibits crystallization of polyethylene terephthalate (PET).

[OPTICAL FILM LAMINATE PRODUCTION PROCESS]

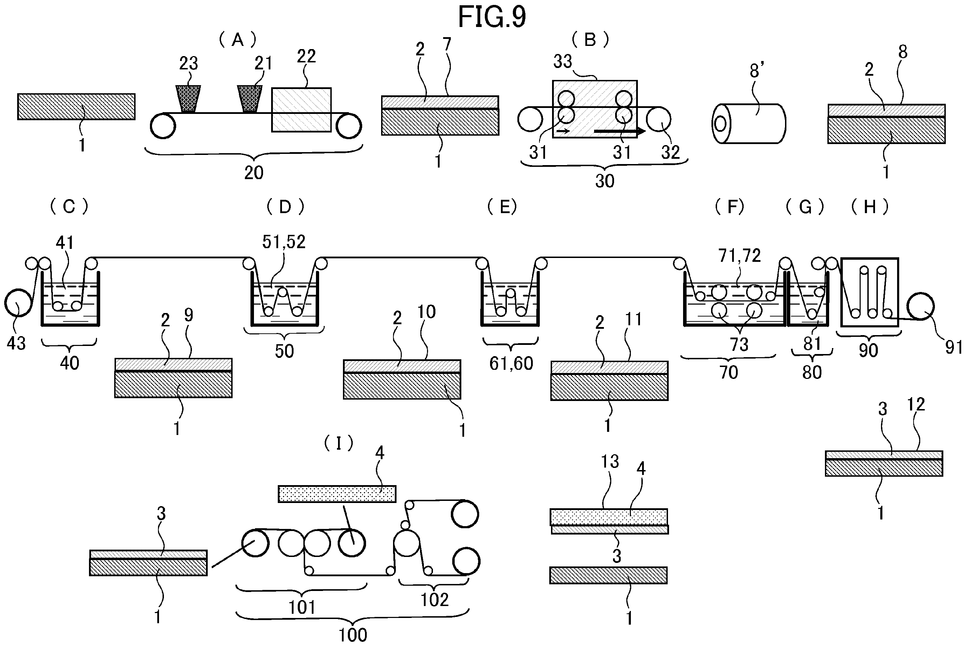

FIG. 9 is a schematic diagram illustrating a production process for an optical film laminate including a polarizing film. With reference to FIG. 9, an outline of production method for an optical film laminate including the polarizing film of Inventive Example 1 will be described below.

[Laminate Preparation Step (A)]

A continuous web of 200 $\mu$m-thick substrate (produced by Mitsubishi Plastics, Inc., trade name: NOVACLEAR SH046, thickness: 200 $\mu$m) made of isophthalic acid-copolymerized polyethylene terephthalate (hereinafter referred to as "non-crystallizable PET") copolymerized with 6 mole% of isophthalic acid was used as a thermoplastic resin substrate serving as a substrate to which the polarizing film is to be applied. This thermoplastic resin is a non-crystallizable type, so that crystallization is less likely to occur even by applying heat thereto, and a stretching ratio is less likely to be lowered. The continuous web of substrate made of polyethylene terephthalate has a glass transition temperature of 75°C. For comparison, a PVA layer has a glass transition temperature of 80°C.

An aqueous PVA solution obtained by dissolving, in water in a concentration of 4 to 5%, a PVA power (polymerization degree: 4200, saponification degree: 99.2%) added with 1 wt % of acetoacetyl-modified PVA (produced by Nippon Synthetic Chemical Industry Co., Ltd., trade name: Gohsefimer Z200) (polymerization degree: 1200, saponification degree: 99 mol%, acetoacetyl-modification degree: 4.6%) was used. Then, in a laminate preparation apparatus 20 equipped with a coating device 21, a drying device 22 and a surface modifying unit 23, the aqueous PVA solution is applied to the non-crystallizable PET substrate 1 in such a manner as to allow a film thickness after drying to become 12 $\mu$m, and subjected to hot-air drying in an atmosphere at 60°C for 10 minutes to prepare a laminate in which a PVA-based resin film is formed on the substrate. The laminate obtained in the above manner will hereinafter be referred to as "laminate in which a PVA layer is formed on a non-crystallizable PET substrate", "laminate including a PVA layer (PVA layer-including laminate)" or "laminate 7".

The laminate 7 including a PVA layer 2 will be finally produced as a 5 $\mu$m-thick polarizing film 3 through the following process comprising a two-stage stretching process consisting of preliminary in-air stretching and in-boric-acid-solution stretching. While the present invention is intended to use a polarizing film having a thickness of 7 $\mu$m or less, it is possible to prepare a polarizing film having an arbitrary thickness equal to or less than 7 $\mu$m (e.g., 6 $\mu$m, 4 $\mu$m or 3 $\mu$m), by appropriately changing a thickness of the PVA-based resin layer formed on the non-crystallizable PET substrate 1 and an aftermentioned stretching ratio.

[Preliminary in-Air Stretching Step (B)]

In a first-stage preliminary in-air stretching step (B), the laminate 7 including the 12 $\mu$m-thick PVA layer 2 was stretched integrally with the non-crystallizable PET substrate 1 to form a "stretched laminate 8" including the stretched PVA layer 2. Specifically, in a preliminary in-air stretching apparatus 30 having a stretching device 31 provided within an oven 33, the laminate 7 including the PVA layer 2 was subjected to free-end uniaxial stretching through the stretching device 31 within the oven 33 having an internal atmosphere set at a stretching temperature of 130°C which is greater than glass-transition temperatures of the PVA layer and the substrate, so as to attain a stretching ratio of 2.0, thereby forming a stretched laminate 8 including an 8 $\mu$m-thick PVA layer 2. At this stage, the stretched laminate 8 can be rolled up by a take-up unit 32 provided in side-by-side relation to the oven 33, to produce a roll 8' of the stretched laminate 8. In this process for Inventive Example 1, the stretching ratio in the preliminary in-air stretching step is set to 2.0 times. Alternatively, the stretching ratio may be increased up to 3.5 times greater than that in this process.

In this connection, an outline of free-end stretching and fixed-end stretching will be described below. When an elongated film is stretched in a conveyance direction thereof, the film is contracted in a direction perpendicular to a stretching direction along which the film is stretched, i.e., a width direction. The free-end stretching means a technique of stretching a film without suppressing such a contraction. Further, longitudinal uniaxial stretching means a technique of stretching a film only in a longitudinal direction thereof. Free-end uniaxial stretching is a technique typically contrasted with fixed-end uniaxial stretching as a technique of stretching a film while suppressing contraction which would otherwise occur in a direction perpendicular to the stretching direction. As a result of the above free-end uniaxial stretching, the 12 $\mu$m-thick PVA layer 2 included in the laminate 7 is formed as an 8 $\mu$m-thick PVA layer 2 in which PVA molecules are oriented in the stretching direction.

[First Insolubilization Step (C)]

Then, in a first insolubilization step (C), the stretched laminate 8 unrolled from a feeding unit 43 loaded with the roll 8' was subjected to insolubilization to form an insolubilized stretched laminate 9. Obviously, the stretched laminate 9 insolubilized in this step includes an insolubilized PVA layer 2. This laminate will hereinafter be referred to as "insolubilized stretched laminate 9".

Specifically, in a first insolubilization apparatus 40 holding a first insolubilizing aqueous boric acid solution 41, the stretched laminate 8 was immersed in the first insolubilizing aqueous boric acid solution 41 set at a solution temperature of 30°C, for 30 seconds. The first insolubilizing aqueous boric acid solution 41 used in this step contains 3 weight parts of boric acid with respect to 100 weight parts of water. This step is intended to subject the stretched laminate 8 to insolubilization for preventing dissolution of the PVA layer included in the stretched laminate 8 at least in a subsequent dyeing step (D).

[Dyeing Step (D)]

Then, in a dyeing step (C), a dyed laminate 10 in which iodine as a dichroic material is adsorbed to the 8 $\mu$m-thick PVA layer 2 having molecularly-oriented PVA molecules was formed. Specifically, in a dyeing apparatus 50 which comprises a dyeing bath 52 of a dyeing solution 51 containing iodine and potassium iodide, the insolubilized stretched laminate 9 fed out from the first insolubilization apparatus 40 was immersed in the dyeing solution 51 set at a solution temperature of 30°C to form a dyed laminate 10 in which iodine is adsorbed to the molecularly-oriented PVA layer 2 of the insolubilized stretched laminate 9.

In this step, in order to prevent dissolution of the PVA layer 2 included in the stretched laminate 8, an iodine concentration and a potassium iodide concentration were set, respectively, in the range of 0.08 to 0.25 weight% and the range of 0.56 to 1.75 weight%, and a concentration ratio of iodine to potassium iodide is set to 1 : 7. The iodine concentration, the potassium iodide concentration and an immersion time in this step exerts a large influence on a concentration of elemental iodine contained in the PVA layer. Therefore, a single transmittance of a final polarizing film can be adjusted by adjusting the iodine concentration, the potassium iodide concentration and the immersion time in this step. For example, in this process, it is possible to adjust the iodine concentration and the potassium iodide concentration within the above respective ranges of the iodine and potassium iodide concentrations, and further adjust the immersion time, to allow iodine to be adsorbed to the molecularly-oriented PVA layer 2 of the stretched laminate 8, in such a manner that a PVA layer included in a polarizing film 3 to be finally formed has a single transmittance of 45%. In Inventive Example 1, the single transmittance is adjusted to 45.0%. Alternatively, it may be adjusted to 44.0%, 44.3%. 44.5 or 45.5%.

[Second Insolubilization Step (E)]

A second insolubilization step (E) described below is performed for the following purposes. This step has a first purpose of insolubilization for preventing dissolution of the PVA layer 2 included in the dyed laminate 10, a second purpose of dye stabilization for preventing elution of iodine adsorbed to dye the PVA layer 2, and a third purpose of node formation for mutually cross-linking PVA molecules of the PVA layer 2 to form nodes. In particular, the second insolubilization step is intended to achieve the first and second purposes.

The second insolubilization step (E) is performed as a preceding step with respect to an aftermentioned in-boric-acid-solution stretching (F). The dyed laminate 10 formed in the dyeing step (D) was subjected to insolubilization to form an insolubilized dyed laminate 11. This laminate will hereinafter be referred to as "insolubilized dyed laminate 11". The insolubilized dyed laminate 11 includes an insolubilized PVA layer 2. Specifically, in a second insolubilization apparatus 60 holding an aqueous solution comprising boric acid and potassium iodide (hereinafter referred to as "second insolubilizing aqueous boric acid solution") 61, the dyed laminate 10 was immersed in the second insolubilizing aqueous boric acid solution 61 set at a solution temperature of 40°C, for 60 seconds, to cause PVA molecules of the PVA layer with iodine adsorbed thereto to be mutually cross-linked, thereby forming an insolubilized dyed laminate 11. The second insolubilizing aqueous boric acid solution 61 used in this step contains 3 weight parts of boric acid with respect to 100 weight parts of water, and further contains 3 weight parts of potassium iodide with respect to 100 weight parts of water.

[In-Boric-Acid-Solution Stretching Step (F)]

In a second-stage in-boric-acid-solution stretching step, the insolubilized dyed laminate 11 including the PVA layer 2 having molecularly-oriented iodine was further stretched to form an optical film laminate 12 which includes a PVA layer having molecularly-oriented iodine and making up a 5 $\mu$m-thick polarizing film 3. Specifically, in an in-boric-acid-solution stretching apparatus 70 which comprises a boric acid bath 72 of an aqueous boric acid solution 71 containing boric acid and potassium iodide, and a stretching device 73, the insolubilized dyed laminate 11 continuously fed out from the second insolubilization apparatus 60 was immersed in the aqueous boric acid solution 71 set at a solution temperature of 70°C degree, and then subjected to free-end uniaxial stretching through the stretching device 73 comprised in the in-boric-acid-solution stretching apparatus 70, so as to attain a stretching ratio of 2.7 times, thereby forming an optical film laminate 12. In this process, a total stretching ratio is 5.4 times. However, in the present invention, the total stretching ratio may be set in the range of 5.6 to 6.5 times, by adjusting respective stretching ratios in the preliminary in-air stretching step and the in-boric-acid-solution stretching step.

More specifically, the aqueous boric acid solution 71 was adjusted to contain 6.5 weight parts of boric acid with respect to 100 weight parts of water, and further contain 5 weight parts of potassium iodide with respect to 100 weight parts of water. In the polarizing film of the present invention, the transmittance is relatively high, i.e., the number of cross-liking nodes where polyiodide ions are adsorbed to PVA is relatively small, so that, in this step and a subsequent cleaning step, polyiodide ions and iodine ions are more likely to be eluted. Therefore, a boric acid concentration of the aqueous boric acid solution in this step is increased as compared to conventional techniques, to thereby reduce an amount of elution of polyiodide ions adsorbed to PVA (and iodine ions and potassium iodide ions). For example, in an aftermentioned process for preparing Comparative Example, the boric acid concentration of the aqueous boric acid solution used in the in-boric-acid-solution stretching step is set to 4 weight parts, whereas, in this process, it is set to 6.5 weight parts.

In this step, the insolubilized dyed laminate 11 subjected to the adjustment of an adsorbed iodine amount was immersed in the aqueous boric acid solution 71 for 5 to 10 seconds. Then, the insolubilized dyed laminate 11 in the immersed state was subjected to free-end uniaxial stretching through a plurality of roll sets each having a different circumferential velocity, as the stretching device 73 of the in-boric-acid-solution stretching apparatus 70, so as to attain a stretching ratio of 2.7 times by taking 30 to 90 seconds. As a result of this stretching, the PVA layer included in the cross-linked dyed laminate 11 was changed to a 5 $\mu$m-thick PVA layer in which polyiodide ions ($I_3^-$ and $I_5^-$) are highly oriented in one direction in the form of a PVA-iodine complex. This PVA layer makes up a polarizing film 3 of the optical film laminate 12.

[Cleaning Step (G)]

The insolubilized dyed laminate 11 was subjected to stretching in the in-boric-acid-solution stretching step (F), and then extracted from the aqueous boric acid solution 71. The extracted optical film laminate 12 including the polarizing film 3 was fed to a cleaning step (G). The cleaning step (G) is intended to wash out unnecessary residues adhering on a surface of the thinned and high-performance polarizing film 3. Specifically, the optical film laminate 12 was fed into a cleaning apparatus 80, and immersed in a cleaning solution 81 containing potassium iodide and set at a solution temperature of 30°C, for 1 to 10 seconds, in such a manner as to avoid dissolution of PVA of the thinned and high-performance polarizing film 3. A concentration of iodine in the cleaning solution 81 is 2.0 weight parts with respect to 100 weight parts of water.

In the present invention, it is necessary that an amount of elemental potassium contained in a polarizing film is set to be less than an amount of elemental iodine contained in the polarizing film. In this situation, an amount of potassium ions contained in the polarizing film is largely influenced by a potassium ion concentration of the cleaning solution in the cleaning step. That is, the amount of potassium ions contained in the polarizing film can be reduced by reducing the potassium ion concentration of the cleaning solution. A potassium iodide concentration of the cleaning solution used for preparation of Inventive Example 1 is 2.0 weight parts, which is less than a potassium iodide concentration (4.0 weight parts) of a cleaning solution used in the aftermentioned process for preparation of Comparative Example, as a conventional technique. The mole ratio of elemental iodine to elemental potassium contained in the polarizing film can be increased by reducing the potassium iodide concentration in the cleaning solution in this step to reduce the amount of elemental potassium contained in the polarizing film.

[Drying Step (H)]

The cleaned optical film laminate 12 was fed to a drying step (H) and dried therein. Then, the dried optical film laminate 12 was wound on a take-up unit 91 provided in side-by-side relation to a drying apparatus 90, as a continuous web of the optical film laminate 12, to form a roll of the optical film laminate 12 including the thinned and high-performance polarizing film 3. In the drying step (H), any suitable technique, such as natural drying, blow drying and thermal drying, may be employed. In this process, the drying was performed by warm air at 60°C for 240 seconds in the oven type drying apparatus 90.

[Lamination and Transfer Step (I)]

Based on a thickness reduction by stretching, the polarizing film 3 produced in this process has a thickness of only 5 $\mu$m. Thus, it is difficult to handle such a thin polarizing film 3 as a single layer body, non-laminate. For this reason, it is common to handle the polarizing film 3, for example, in the form of the optical film laminate 12, i.e., in a state in which it is left on the non-crystallizable PET substrate 1, or, in the form of an optically functional film laminate 13 prepared by laminating the optical film laminate 12 to an additional optically functional film 4 through an adhesive and peeling off the non-crystallizable PET substrate 1 to thereby transfer the polarizing film 3 from to the non-crystallizable PET substrate 1 to the optically functional film 4. In this process, a 40 $\mu$m-thick protective layer (acrylic-based film) was laminated to one surface of the polarizing film on an opposite of the other surface in contact with the non-crystallizable PET substrate, by using an adhesive, to prepare an optically functional film laminate 13, and the optically functional film laminate 13 was subjected to measurement of optical properties as Inventive Example.

Further, a peeling film for protection may be releasably provided on one of opposite surfaces of the optically functional film laminate 13 on an opposite side of the other surface defined by the optically functional film (protective layer) laminated thereto, through a pressure-sensitive layer. Alternatively, a second optically functional film, such as a retardation layer for generating circularly-polarized light in cooperation with the polarizing film, may be provided on one of opposite surfaces of the optically functional film laminate 13 on an opposite side of the other surface defined by the first optically functional film (protective layer) laminated thereto, and further a peeling film for protection may be releasably provided on a surface of the optically functional film laminate 13 defined by the second optically functional film laminated thereto, through a pressure-sensitive layer. In the above alternative, the protective layer and the retardation film were used, respectively, as a first optically functional film and a second optically functional film. Further, according to need, an optically functional film having a different function may be additionally laminated, and a peeling film to be attached through a pressure sensitive adhesive may be attached to either one or each of opposite surfaces of the optically functional film laminate, depending on intended purposes.

[Inventive Examples 2 and 3]

Except that the content of potassium iodide in the cleaning solution in the cleaning step is set to 1 weight part with respect to 100 weight parts of water, Inventive Example 2 was prepared in the same manner as that for Inventive Example 1. Further, except that the content of potassium iodide in the cleaning solution is set to 0.5 weight parts with respect to 100 weight parts of water, Inventive Example 3 was prepared in the same manner as that for Inventive Example 1.

[Comparative Example]

Except that the boric acid concentration of the aqueous boric acid solution in the in-boric-acid-solution stretching step is set to 4 weight parts with respect to 100 weight parts of water (the potassium iodide concentration is the same), the potassium iodide concentration in the cleaning solution in the cleaning step is set to 4 weight parts with respect to 100 weight parts of water, Comparative Example was prepared in the same manner as that for Inventive Example 1.

[Reference Example 1]

Except that the insolubilized stretched laminate is immersed in the dyeing solution in the dyeing step while adjusting the iodine concentration in the dyeing solution and the dying (immersion) time to allow a single transmittance of a finally obtained PVA layer to be 42.8%, Reference Example 1 was prepared in the same manner as that for Inventive Example 1.

[Reference Example 2]

A 60 μm-thick polyvinyl alcohol film (produced by Kuraray Co., Ltd, trade name: PE6000) was subjected to longitudinal uniaxially stretching by using a roller stretching machine, and simultaneously subjected to swelling, dyeing, cross-linking and cleaning. Then, the cleaned film was finally subjected to drying to prepare a 23 μm-thick polarizing film of Reference Example 2.

[ORGANIC EL DISPLAY DEVICE]

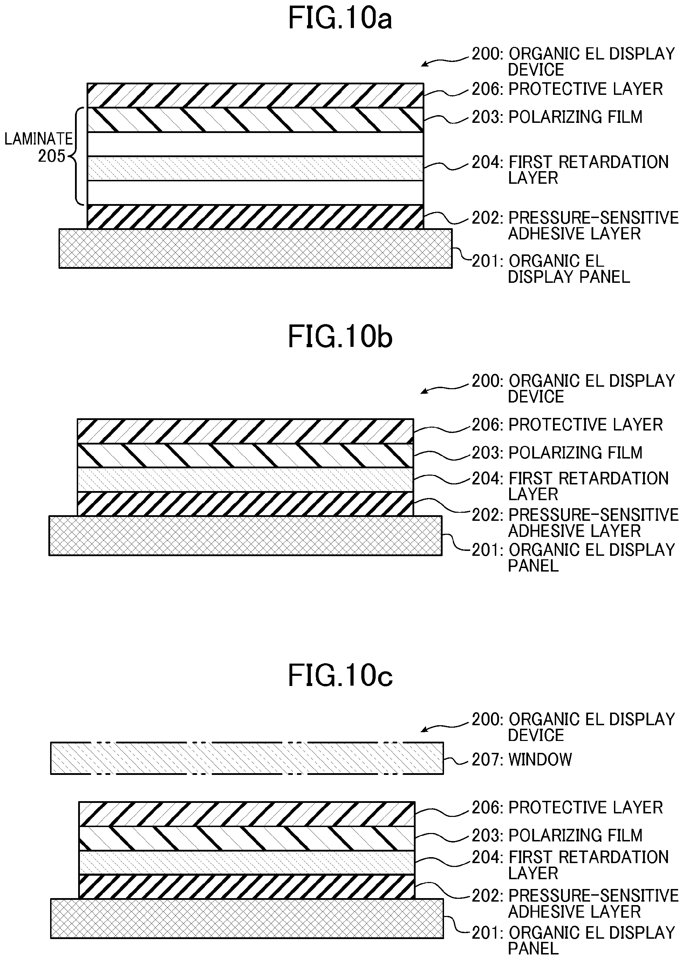

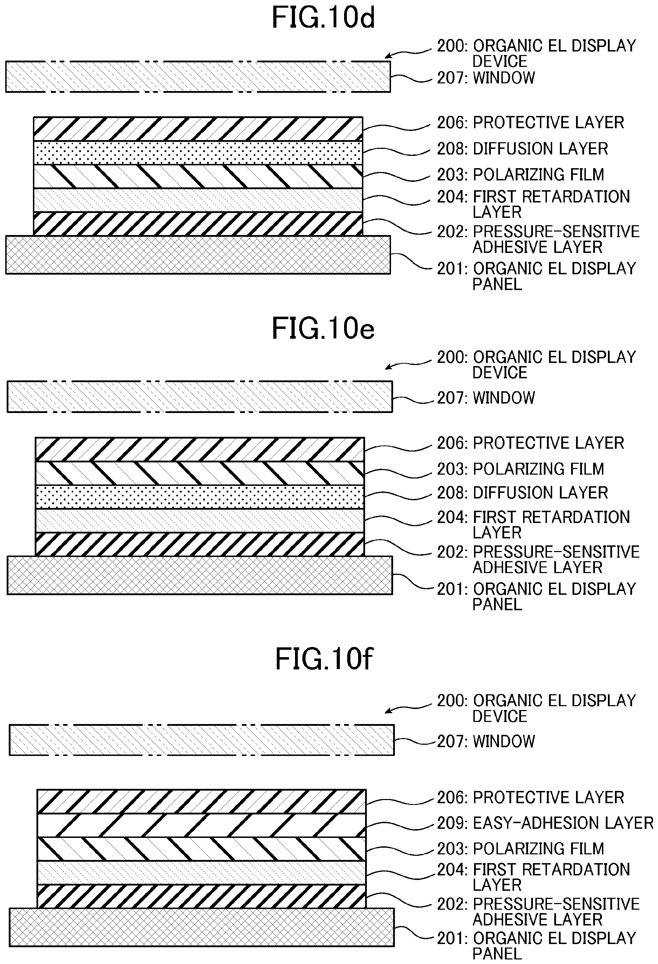

FIGS. 10a to 12b illustrate organic EL display devices each using the above polarizing film, according to some embodiments of the present invention.

FIG. 10a is a sectional view illustrating the most basic example of an organic EL display device according to a first embodiment of the present invention. This organic EL display device 200 comprises an organic EL display panel 201, and a laminate 205 including a polarizing film 203 and a first retardation layer 204. The laminate 205 is bonded to one of opposite surfaces of the organic EL display panel 201 through an optically transparent pressure-sensitive adhesive layer 202. The polarizing film 203 and the first retardation layer 204 are configured to produce circularly-polarized light so as to prevent light entering from a viewing side of the polarizing film 203 from exiting toward the viewing side after internally reflection. A protective layer 206 made of an optically transparent resin material is adhesively bonded to an outer surface of the polarizing film 203.

As illustrated in FIG. 10b, the polarizing film 203 and the first retardation layer 204 may be selectively bonded together, and the first retardation layer 204 and the pressure-sensitive adhesive layer 202 may also be selectively bonded together. For the sake of simplicity, the following description will be made on an assumption that the laminate 205 consists only of the polarizing film 203 and the first retardation layer 204, wherein the first retardation layer 204 and the pressure-sensitive adhesive layer 202 are bonded together.

Optionally, a transparent window 207 as indicated by the dotted line in FIG. 10c may be disposed on an outer side of the protective layer 206, wherein the outer side of the protective layer 206 corresponds to a viewing side of the organic EL display device.

The polarizing film 203 is formed to have a thickness of 7 $\mu$m or less, and exhibit a high durability. This polarizing film 203 is extremely thin, so that stress arising from expansion/contraction occurring depending on conditions of temperature or humidity becomes significantly small. Thus, it becomes possible to considerably reduce a risk that stress arising from expansion/contraction of the polarizing film causes deformation, such as warp, in the organic EL display panel 201 adjacent thereto, and drastically suppress deterioration in quality of display due to the deformation and destruction of a panel sealing material. As compared to polarizing films used in this type of conventional optical display device, the polarizing film 203 has a small thickness and exhibits a high transmittance and excellent durability, and can withstand the above durability test. This means that it can maintain performance necessary for an organic EL display device over a practically required period of use.

In this structure, as the pressure-sensitive adhesive layer 202, a material having a diffusing function may be used, or a two-layer structure of a pressure-sensitive adhesive layer and a diffusion layer may be employed.

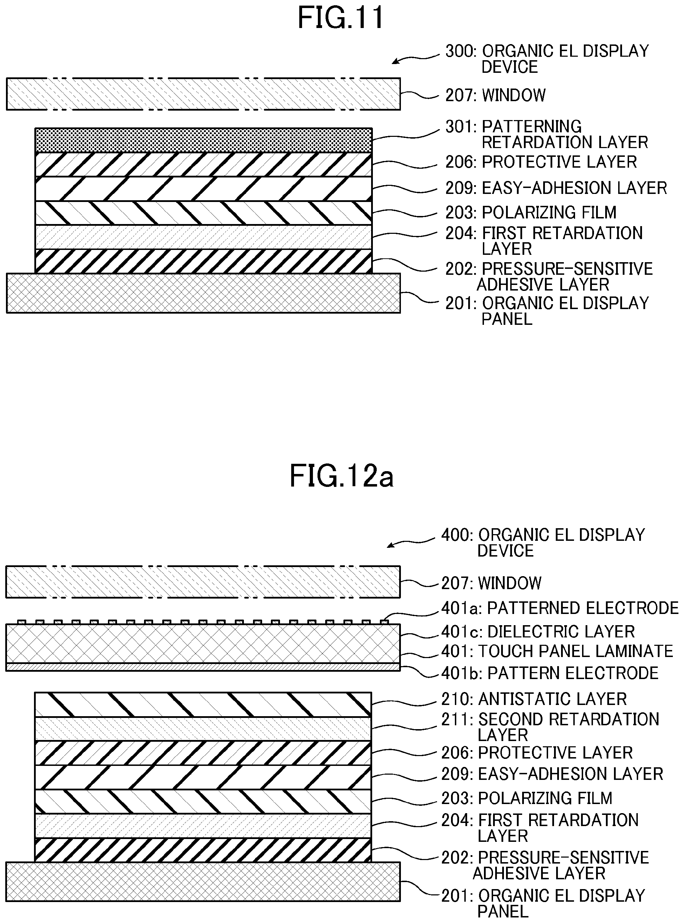

An optical display device illustrated in FIG. 10d has substantially the same structure as those illustrated in FIGS. 10a to 10c, except that a diffusion layer 208 is disposed between the polarizing film 203 and the protective layer 206. In a structure illustrated in FIG. 11e, the diffusion layer 208 is disposed between the polarizing film 203 and the organic EL display panel 201.

An optical display device illustrated in FIG. 10f has fundamentally the same structure as those illustrated in FIGS. 11 a to 11c, except that the polarizing film 203 is adhesively bonded to the protective layer 206 through an easy-adhesion layer 209. A material for use as the easy-adhesion layer is commonly known to those skilled in the art.

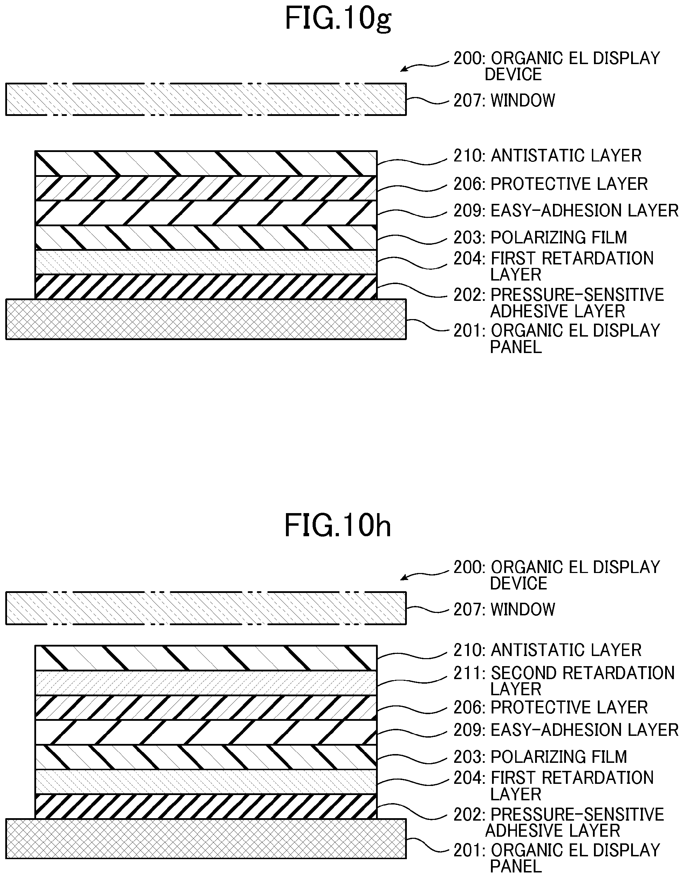

An optical display device illustrated in FIG. 10g is different from the optical display device illustrated in FIG. 10f, only in that an antistatic layer 210 is provided on an outer side of the protective layer 206.

In an optical display device 200 illustrated in FIG. 10h, a second retardation layer 211 for producing circularly-polarized light in cooperation with a polarizing film, such as a 1/4 wavelength retardation layer, is disposed between the protective layer 206 and the antistatic layer 210 in the organic EL display device illustrated in FIG. 10g. In this structure, the retardation layer for producing circularly-polarized light in cooperation with a polarizing film is disposed on the viewing side with respect to the polarizing film 203, so that light exiting from the organic EL display panel 201 via the polarizing film 203 is converted into circularly-polarized light when it exits from the second retardation layer 211. The organic EL display device having this structure provides an advantage of being able to eliminate a problem with viewing even when a viewer wears a polarized sunglass.

In an organic EL display device 300 illustrated in FIG. 11, a first retardation film 204 is bonded to a viewing-side surface of an organic EL display panel 201, and a polarizing film 203 is bonded to the first retardation film 204 through an adhesive. The polarizing film 203 is bonded to a protective layer 204 through an easy-adhesion layer 209, and a patterning retardation layer 301 is bonded to the protective layer 204. The patterning retardation layer 301 may be formed as a patterning retardation layer as disclosed in the Non-Patent Document 1. The patterning retardation layer has a function of allow respective polarization states of an image for right eye and an image for left eye output from the display panel to become different from each other. Optionally, a window 207 may be disposed on an outer side of the patterning retardation layer 301.

FIG. 12a illustrates an organic EL display device 400 according to another embodiment of the present invention, wherein the organic EL display device 400 has a touch input sensor function. A structure of a device body of the optical display device 400 is substantially the same as that illustrated in FIG. 10h. Thus, a corresponding element is defined by the same reference numeral or code as that in FIG. 10h, and its description will be omitted. In this embodiment, a touch panel laminate 401 is disposed between an antistatic layer 210 and a window 207. The touch panel laminate 401 may be a capacitive touch panel or may be a resistive touch panel. As for the capacitive tough panel, as illustrated in FIG. 12a, an upper patterned electrode 401a and a lower patterned electrode 401b are disposed opposed to each other while interposing a dielectric layer 401c therebetween. As the capacitive touch panel laminate, any conventional structure may be employed as well as the illustrated structure. In the case where the touch panel laminate 401 is formed as a resistive type, a spacer may be disposed between an upper electrode and a lower electrode to define an air gap between the two electrodes. Various configurations of such a touch panel laminate are known, and any one of them may be employed in this embodiment.

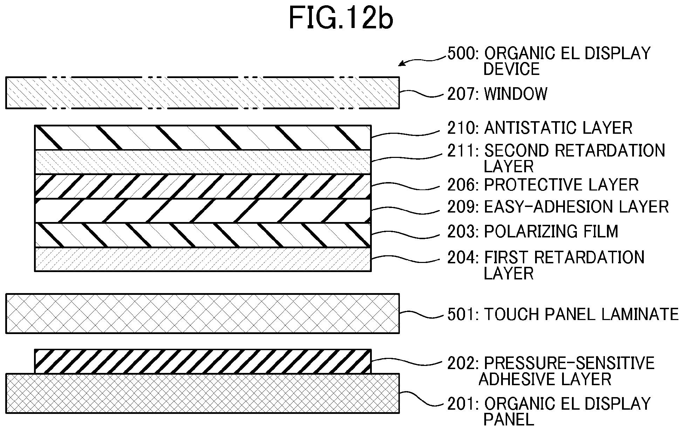

FIG. 12b illustrates an organic EL display device 500 according to still another embodiment of the present invention, wherein the organic EL display device 500 has a touch input sensor function. A structure of a device body of the optical display device 500 is substantially the same as that illustrated in FIG. 10h. Thus, a corresponding element is defined by the same reference numeral or code as that in FIG. 10h, and its description will be omitted. In this embodiment, a touch panel laminate 501 is disposed between an organic EL display panel 201 and a first retardation film 204. As with the embodiment illustrated FIG. 12a, a touch panel laminate 401 in this embodiment may be a capacitive touch panel or may be a resistive touch panel.

Although the present invention has been described in term of specific exemplary embodiments, it is to be understood that the present invention is not limited to details of the embodiments, but only by the appended claims and their legal equivalents.

EXPLANATION OF CODES

1: non-crystallizable PET substrate
2: PET-based resin layer
3: polarizing film
4: optically functional film
7: PVA-based resin layer-including laminate
8: stretched laminate
8': roll of stretched laminate
9: insolubilized stretched laminate
10: dyed laminate
11: cross-linked dyed laminate
12: optical film laminate
13: optical film laminate
20: laminate preparation apparatus
21: coating device
22: drying device
23: surface modifying unit
30: preliminary in-air stretching apparatus
31: stretching device
32: take-up unit
33: oven
40: first insolubilization apparatus
41: first insolubilizing aqueous boric acid solution
43: feeding unit
50: dyeing apparatus
51: dyeing solution
52: dyeing bath
60: second insolubilization apparatus
61: second insolubilizing aqueous boric acid solution
70: in-boric-acid-solution stretching apparatus
71: aqueous boric acid solution
72: boric acid bath
73: stretching device
80: cleaning apparatus
81: cleaning solution
90: drying apparatus
91: take-up unit
100: lamination and transfer apparatus
101: unrolling and laminating apparatus
102: take-up and transfer apparatus
200: organic EL display device
201: organic EL display panel
202: pressure-sensitive adhesive layer
203: polarizing film
204: first retardation layer
205: laminate
206: protective layer
207: window

208: diffusion layer
209: easy-adhesion layer
210: antistatic layer
211: second retardation layer
300: organic EL display device
301: patterning retardation layer
400: organic EL display device
401: touch panel laminate
401a: patterned electrode
401b: patterned electrode
401c: dielectric layer
500: organic EL display device
501: touch panel laminate
(A): laminate preparation step
(B): preliminary in-air stretching step
(C): first insolubilization step
(D): dyeing step
(E): second insolubilization step
(F): in-boric-acid-solution stretching step
(G): cleaning step
(H): drying step
(I): laminating and transfer process

**Claims**

1. A polarizing film in the form of a continuous web, the polarizing film being comprised of a polyvinyl alcohol-based resin containing potassium and molecularly-oriented iodine, wherein the polarizing film has a thickness of 7 $\mu$m or less, and exhibits a single transmittance of 44.0% or more, and wherein a mole ratio (I/K) of elemental iodine (I) to elemental potassium (K) contained in the polarizing film is 1.8 or more whereby the mole ratio (I/K) results from cleaning the polarizing film with an aqueous potassium iodide solution.

2. The polarizing film as defined in claim 1, wherein an elemental iodine concentration in the polarizing film is 6 weight% or less.

3. The polarizing film as defined in claim 1 or 2, wherein the mole ratio is 3.0 or less.

4. The polarizing film as defined in any one of claims 1 to 3, wherein the single transmittance of the polarizing film is 44.3% or more.

5. The polarizing film as defined in any one of claims 1 to 4, wherein the thickness of the polarizing film is 5 $\mu$m or less.

6. An optically functional film laminate comprising the polarizing film as defined in any one of claims 1 to 5; an optically functional film provided on the side of one of opposite surfaces of the polarizing film; and a peeling film releasably provided on the side of the other surface through a pressure-sensitive adhesive layer.

7. An optically functional film laminate comprising: the polarizing film as defined in any one of claims 1 to 5; a first optically functional film provided on the side of one of opposite surfaces of the polarizing film; and a second optically functional film provided on the side of the other surface, wherein the optically functional film laminate further comprises a peeling film releasably provided on one of opposite surface thereof through a pressure-sensitive adhesive layer.

8. An optically functional film laminate comprising: the polarizing film as defined in any one of claims 1 to 5; a protective layer provided on the side of one of opposite surfaces of the polarizing film; and a retardation layer provided on the side of the other surface and configured to generate circularly-polarized light in cooperation with the polarizing film, wherein the optically functional film laminate further comprises a peeling film releasably provided on one surface thereof through a pressure-sensitive adhesive layer.

9. An organic EL display device comprising an optically functional film laminate which includes: the polarizing film as defined in any one of claims 1 to 5; a first retardation layer on the side of one of opposite surfaces of the polarizing film; and a protective layer of a transparent resin material on the side of the other surface, the optically functional film laminate being provided on one surface of an organic EL display panel through a pressure-sensitive adhesive layer lying on the side of the first retardation layer, wherein the optically functional film laminate is operable to generate circularly-polarized light so as to prevent light entering from a viewing side of the polarizing film from exiting toward the viewing side after internal reflection.

10. A method of producing an optical film laminate in which a polarizing film comprised of a polyvinyl alcohol-based resin having molecularly-oriented iodine is formed on a non-crystallizable ester-based thermoplastic resin substrate in the form of a continuous web, wherein the polarizing film has a thickness of 7 μm or less, and exhibits a single transmittance of 44.0% or more, the method comprising:

a first stretching step of subjecting a laminate including the non-crystallizable ester-based thermoplastic resin substrate and a polyvinyl alcohol-based resin layer formed on the non-crystallizable ester-based thermoplastic resin substrate, to in-air stretching to form a stretched laminate comprising a stretched intermediate product consisting of a molecularly-oriented polyvinyl alcohol-based resin layer;
a first insolubilization step of subjecting the stretched intermediate product comprised in the stretched laminate to insolubilization to form an insolubilized stretched laminate;
a dyeing step of adsorbing iodine to the insolubilized stretched laminate to form a dyed laminate;
a second insolubilization step of subjecting the stretched intermediate product comprised in the dyed laminate to insolubilization to form an insolubilized dyed laminate;
a second stretching step of subjecting the insolubilized dyed laminate to stretching in an aqueous boric acid solution to form an optical film laminate including a polarizing film comprised of a polyvinyl alcohol-based resin having molecularly-oriented iodine; and
a cleaning step of cleaning the optical film laminate by an aqueous potassium iodide solution to allow a mole ratio (I/K) of elemental iodine (I) to elemental potassium (K) contained in the polarizing film to be 1.8 or more.

11. The method as defined in claim 10, wherein the first insolubilization step consists of a step of immersing the stretched laminate in an aqueous boric acid solution.

12. The method as defined in claim 10 or 11, wherein the second insolubilization step consists of a step of immersing the dyed laminate in an aqueous boric acid solution.

13. The method as defined in any one of claims 10 to 12, wherein the second stretching step consists of a step of stretching the insolubilized dyed laminate in an aqueous boric acid solution containing boric acid in an amount of 6 weight parts or more with respect to 100 weight parts of water, to form an optical film laminate including a polarizing film comprised of a polyvinyl alcohol-based resin having molecularly-oriented iodine.

14. The method as defined in any one of claims 10 to 13, wherein the cleaning step consists of a step of cleaning the optical film laminate by an aqueous potassium iodide solution containing potassium iodide in an amount of 0.5 to 2 weight parts with respect to 100 weight parts of water.

15. The method as defined in any one of claims 10 to 14, wherein the non-crystallizable thermoplastic resin substrate is a non-crystallizable ester-based thermoplastic resin substrate.

16. The method as defined in claim 15, wherein the non-crystallizable ester-based thermoplastic resin consists of non-crystallizable polyethylene terephthalate including polyethylene terephthalate copolymerized with isophthalic acid, polyethylene terephthalate copolymerized with cyclohexanedimethanol or other copolymerized polyethylene terephthalate, wherein the non-crystallizable polyethylene terephthalate is set to have an orientation function of 0.10 or less, and subjected to elevated-temperature in-air stretching in-air stretching.

17. The method as defined in any one of claims 10 to 16, wherein the non-crystallizable thermoplastic resin substrate is made of a transparent resin.

18. The method as defined in any one of claims 10 to 17, which further comprises a step of applying a polyvinyl alcohol-based resin onto the non-crystallizable thermoplastic resin substrate and drying the applied polyvinyl alcohol-based resin to form a polyvinyl alcohol-based resin layer on the non-crystallizable thermoplastic resin substrate.

**19.** The method as defined in any one of claims 10 to 18, wherein the first stretching step is performed at a stretching ratio of 3.5 times or less.

**20.** The method as defined in any one of claims 10 to 19, wherein the first stretching step is performed at a stretching temperature equal to or greater than a glass transition temperature of the polyvinyl alcohol-based resin.

**21.** The method as defined in any one of claims 10 to 20, wherein a total stretching ratio for the stretched laminate and the dyed laminate in the first and second stretching steps is set in the range of 5.0 to 6.5 times.

**Patentansprüche**

**1.** Polarisierender Film in der Form einer kontinuierlichen Bahn, wobei der polarisierende Film aus einem Kalium und molekular orientiertes Iod enthaltenden Harz auf Polyvinylalkoholbasis besteht, wobei der polarisierende Film eine Dicke von höchstens 7 μm hat und eine Einzeldurchlässigkeit von wenigstens 44,0 % aufweist, und wobei ein Molverhältnis (I/K) von elementarem Iod (I) zu elementarem Kalium (K) in dem polarisierenden Film wenigstens 1,8 beträgt, wobei das Molverhältnis (I/K) aus dem Reinigen des polarisierenden Films mit einer wässrigen Kalium-Iod-Lösung hervorgeht.

**2.** Polarisierender Film nach Anspruch 1, wobei eine Konzentration von elementarem Iod in dem polarisierenden Film höchstens 6 Gew.-% beträgt.

**3.** Polarisierender Film nach Anspruch 1 oder 2, wobei das Molverhältnis höchstens 3,0 beträgt.

**4.** Polarisierender Film nach einem der Ansprüche 1 bis 3, wobei die Einzeldurchlässigkeit des polarisierenden Films wenigstens 44,3 % beträgt.

**5.** Polarisierender Film nach einem der Ansprüche 1 bis 4, wobei die Dicke des polarisierenden Films höchstens 5 μm beträgt.

**6.** Optisch wirksames Filmlaminat, umfassend den polarisierenden Film nach einem der Ansprüche 1 bis 5; einen optisch wirksamen Film, bereitgestellt auf der Seite einer der einander gegenüberliegenden Oberflächen des polarisierenden Films; und eine Abziehfolie, entfernbar mithilfe einer druckempfindlichen Klebstoffschicht auf der Seite der anderen Oberfläche bereitgestellt.

**7.** Optisch wirksames Filmlaminat, umfassend den polarisierenden Film nach einem der Ansprüche 1 bis 5; einen ersten optisch wirksamen Film, bereitgestellt auf der Seite einer der einander gegenüberliegenden Oberflächen des polarisierenden Films; und einen zweiten optisch wirksamen Film, bereitgestellt auf der Seite der anderen Oberfläche, wobei das optisch wirksame Filmlaminat ferner eine Abziehfolie umfasst, entfernbar mithilfe einer druckempfindlichen Klebstoffschicht auf einer der einander gegenüberhegenden Oberflächen bereitgestellt.

**8.** Optisch wirksames Filmlaminat, umfassend den polarisierenden Film nach einem der Ansprüche 1 bis 5; eine Schutzschicht, bereitgestellt auf der Seite einer der einander gegenüberliegenden Oberflächen des polarisierenden Films; und eine Verzögerungsschicht, bereitgestellt auf der Seite der anderen Oberfläche, und konfiguriert, gemeinsam mit dem polarisierenden Film zirkulär polarisiertes Licht zu erzeugen, wobei das optisch wirksame Filmlaminat ferner eine Abziehfolie umfasst, entfernbar mithilfe einer druckempfindlichen Klebstoffschicht auf einer Oberfläche davon bereitgestellt.

**9.** Organische EL-Anzeigevorrichtung, umfassend ein optisch wirksames Filmlaminat, das Folgendes enthält: den polarisierenden Film nach einem der Ansprüche 1 bis 5; eine erste Verzögerungsschicht auf der Seite einer der einander gegenüberliegenden Oberflächen des polarisierenden Films; und eine Schutzschicht aus transparentem Harzmaterial auf der Seite der anderen Oberfläche, wobei das optisch wirksame Filmlaminat mithilfe einer auf der Seite der ersten Verzögerungsschicht liegenden druckempfindlichen Klebstoffschicht auf einer Oberfläche eines organischen EL-Anzeigepanels bereitgestellt ist, wobei das optisch wirksame Filmlaminat funktionsfähig ist, zirkulär polarisiertes Licht bereitzustellen, um zu verhindern, dass Licht, welches von einer Betrachtungsseite des polarisierenden Films aus eintritt, nach einer internen Reflexion in die Richtung der Betrachtungsseite austritt.

**10.** Verfahren zum Erzeugen eines optischen Filmlaminats, in dem ein aus einem Harz auf Polyvinylalkoholbasis mit molekular orientiertem Iod bestehender polarisierender Film auf einem nicht kristallisierbaren thermoplastischen Harzsubstrat auf Esterbasis in der Form einer kontinuierlichen Bahn ausgebildet wird, wobei der polarisierende Film eine Dicke von höchstens 7 $\mu$m und eine Einzeldurchlässigkeit von wenigstens 44,0 % aufweist, wobei das Verfahren Folgendes umfasst:

einen ersten Streckschritt des Aussetzens eines Laminats, das das nicht kristallisierbare thermoplastische Harzsubstrat auf Esterbasis und eine auf dem nicht kristallisierbaren thermoplastischen Harzsubstrat auf Esterbasis ausgebildete Harzschicht auf Polyvinylalkoholbasis enthält, einer Luftstreckung zum Ausbilden eines gestreckten Laminats, umfassend ein gestrecktes Zwischenprodukt, das aus einer Harzschicht auf der Basis eines molekular orientierten Polyvinylalkohols besteht;
einen ersten Insolubilisierungsschritt des Aussetzens des in dem gestreckten Laminat enthaltenen gestreckten Zwischenprodukts einer Insolubilisierung, um ein insolubilisiertes gestrecktes Laminat auszubilden;
einen Färbeschritt des Adsorbierens von Iod in das gestreckte Laminat, um ein gefärbtes Laminat auszubilden;
einen zweiten Insolubilisierungsschritt des Aussetzens des in dem gefärbten Laminat enthaltenen gestreckten Zwischenprodukts einer Insolubilisierung, um ein insolubilisiertes gefärbtes Laminat auszubilden;
einen zweiten Streckschritt des Aussetzens des insolubilisierten gefärbten Laminats einer Streckung in einer wässrigen Borsäurelösung zum Ausbilden eines optischen Filmlaminats, einschließlich eines polarisierenden Films, bestehend aus einem Harz auf Polyvinylalkoholbasis mit molekular orientiertem Iod; und
einen Reinigungsschritt des Reinigens des optischen Filmlaminats mithilfe einer wässrigen Kaliumiodidlösung, um zu ermöglichen, dass ein Molverhältnis (I/K) von elementarem Iod (I) zu elementarem Kalium (K) in dem polarisierenden Film wenigstens 1,8 beträgt.

11. Verfahren nach Anspruch 10, wobei der erste Insolubilisierungsschritt aus einem Schritt des Eintauchens des gestreckten Laminats in eine wässrige Borsäurelösung besteht.

12. Verfahren nach Anspruch 10 oder 11, wobei der zweite Insolubilisierungsschritt aus einem Schritt des Eintauchens des gefärbten Laminats in eine wässrige Borsäurelösung besteht.

13. Verfahren nach einem der Ansprüche 10 bis 12, wobei der zweite Streckschritt aus einem Schritt des Streckens des insolubilisierten gefärbten Laminats in einer wässrigen Borsäurelösung besteht, welche Borsäure in einer Menge von wenigstens 6 Gewichtsanteilen mit Bezug auf 100 Gewichtsanteile Wasser enthält, um ein optisches Filmlaminat mit einem polarisierenden Film, der aus einem Harz auf Polyvinylbasis mit molekular orientiertem Iod besteht, auszubilden.

14. Verfahren nach einem der Ansprüche 10 bis 13, wobei der Reinigungsschritt aus einem Schritt des Reinigens des optischen Filmlaminats mithilfe einer wässrigen Kaliumiodidlösung, welche Kaliumiodid in einer Menge von 0,5 bis 2 Gewichtsanteilen mit Bezug auf 100 Gewichtsanteile Wasser enthält, besteht.

15. Verfahren nach einem der Ansprüche 10 bis 14, wobei das nicht kristallisierbare thermoplastische Harzsubstrat ein nicht kristallisierbares thermoplastisches Harzsubstrat auf Esterbasis ist.

16. Verfahren nach Anspruch 15, wobei das nicht kristallisierbare thermoplastische Harz auf Esterbasis aus nicht kristallisierbarem Polyethylenterephthalat besteht, einschließlich mit Isophthalsäure copolymerisiertem Polyethylenterephthalat, mit Cyclohexandimethanol copolymerisiertem Polyethylenterephthalat oder anderem copolymerisiertem Polyethylenterephthalat, wobei das nicht kristallisierbare Polyethylenterephthalat eingestellt ist, eine Orientierungsfunktion von höchstens 0,10 aufzuweisen, und einer erhöhten Temperatur bei Luftstrecken ausgesetzt wird.

17. Verfahren nach einem der Ansprüche 10 bis 16, wobei das nicht kristallisierbare thermoplastische Harzsubstrat aus einem transparenten Harz gefertigt ist.

18. Verfahren nach einem der Ansprüche 10 bis 17, ferner umfassend einen Schritt des Aufbringens eines Harzes auf Polyvinylalkoholbasis auf das nicht kristallisierbare thermoplastische Harzsubstrat und des Trocknens des aufgebrachten Harzes auf Polyvinylalkoholbasis zum Ausbilden einer Harzschicht aus Polyvinylalkoholbasis auf das nicht kristallisierbare thermoplastische Harzsubstrat.

19. Verfahren nach einem der Ansprüche 10 bis 18, wobei der erste Streckschritt bei einem Streckverhältnis von höchstens 3,5-fach ausgeführt wird.

**20.** Verfahren nach einem der Ansprüche 10 bis 19, wobei der erste Streckschritt bei einer Strecktemperatur von wenigstens einer Glasübergangstemperatur des Harzes auf Polyvinylalkoholbasis ausgeführt wird.

**21.** Verfahren nach einem der Ansprüche 10 bis 20, wobei ein Gesamtstreckverhältnis für das gestreckte Laminat und das gefärbte Laminat in dem ersten und dem zweiten Streckschritt im Bereich von 5,0- bis 6,5-fach liegt.

**Revendications**

**1.** Film polarisant sous la forme d'une âme continue, le film polarisant étant composé d'une résine à base de polyalcool vinylique contenant du potassium et de l'iode orienté moléculairement, dans lequel le film polarisant a une épaisseur de 7 μm ou moins, et affiche une transmittance unique de 44,0 % ou plus, et dans lequel un rapport molaire (I/K) d'iode élémentaire (I) sur potassium élémentaire (K) contenu dans le film polarisant est de 1,8 ou plus, moyennant quoi le rapport molaire (I/K) résulte du nettoyage du film polarisant avec une solution aqueuse d'iodure de potassium.

**2.** Film polarisant selon la revendication 1, dans lequel une concentration en iode élémentaire dans le film polarisant est de 6 % en poids ou moins.

**3.** Film polarisant selon la revendication 1 ou 2, dans lequel le rapport molaire est de 3,0 ou moins.

**4.** Film polarisant selon l'une quelconque des revendications 1 à 3, dans lequel la transmittance unique du film polarisant est de 44,3 % ou plus.

**5.** Film polarisant selon l'une quelconque des revendications 1 à 4, dans lequel l'épaisseur du film polarisant est de 5 μm ou moins.

**6.** Stratifié de film optiquement fonctionnel comprenant le film polarisant tel que défini dans l'une quelconque des revendications 1 à 5 ; un film optiquement fonctionnel ménagé sur le côté de l'une des surfaces opposées du film polarisant ; et un film de pelage ménagé de façon libérable sur le côté de l'autre surface par l'intermédiaire d'une couche d'adhésif autocollant.

**7.** Stratifié de film optiquement fonctionnel comprenant : le film polarisant tel que défini dans l'une quelconque des revendications 1 à 5 ; un premier film optiquement fonctionnel ménagé sur le côté de l'une des surfaces opposées du film polarisant ; et un second film optiquement fonctionnel ménagé sur le côté de l'autre surface, dans lequel le stratifié de film optiquement fonctionnel comprend en outre un film de pelage ménagé de façon libérable sur l'une de ses surfaces opposées par l'intermédiaire d'une couche d'adhésif autocollant.

**8.** Stratifié de film optiquement fonctionnel comprenant : le film polarisant tel que défini dans l'une quelconque des revendications 1 à 5 ; une couche protectrice ménagée sur le côté de l'une des surfaces opposées du film polarisant ; et une couche de retardement ménagée sur le côté de l'autre surface et configurée pour générer une lumière en polarisation circulaire en coopération avec le film polarisant, dans lequel le stratifié de film optiquement fonctionnel comprend en outre un film de pelage ménagé de façon libérable sur l'une de ses surfaces par l'intermédiaire d'une couche d'adhésif autocollant.

**9.** Dispositif d'affichage électroluminescent organique comprenant un stratifié de film optiquement fonctionnel qui inclut : le film polarisant tel que défini dans l'une quelconque des revendications 1 à 5 ; une première couche de retardement sur le côté de l'une des surfaces opposées du film polarisant ; et une couche protectrice d'un matériau de résine transparent sur le côté de l'autre surface, le stratifié de film optiquement fonctionnel étant ménagé sur une surface d'un panneau d'affichage électroluminescent organique par l'intermédiaire d'une couche d'adhésif autocollant reposant sur le côté de la première couche de retardement, dans lequel le stratifié de film optiquement fonctionnel est opérationnel pour générer une lumière en polarisation circulaire de manière à empêcher la lumière entrant depuis un côté visualisation du film polarisant de sortir vers le côté visualisation après réflexion interne.

**10.** Procédé de production d'un stratifié de film optique dans lequel un film polarisant comprenant une résine à base de polyalcool vinylique ayant de l'iode orienté moléculairement est formé sur un substrat de résine thermoplastique à base d'ester non cristallisable sous la forme d'une âme continue, dans lequel le film polarisant a une épaisseur de 7 μm ou moins, et affiche une transmittance unique de 44,0 % ou plus, le procédé comprenant :

une première étape d'étirement consistant à soumettre le stratifié incluant le substrat de résine thermoplastique à base d'ester non cristallisable et une couche de résine à base de polyalcool vinylique formée sur le substrat de résine thermoplastique à base d'ester non cristallisable, à un étirement dans l'air pour former un stratifié étiré comprenant un produit intermédiaire étiré consistant en une couche de résine à base de polyalcool vinylique orienté moléculairement ;

une première étape d'insolubilisation consistant à soumettre le produit intermédiaire étiré compris dans le stratifié étiré à une insolubilisation pour former un stratifié étiré insolubilisé ;

une étape de teinture consistant à adsorber de l'iode sur le stratifié étiré insolubilisé pour former un stratifié teinté ;

une seconde étape d'insolubilisation consistant à soumettre le produit intermédiaire étiré compris dans le stratifié teinté à une insolubilisation pour former un stratifié teinté insolubilisé ;

une seconde étape d'étirement consistant à soumettre le stratifié teinté insolubilisé à un étirement dans une solution aqueuse d'acide borique pour former un stratifié de film optique incluant un film polarisant composé d'une résine à base de vinylique ayant de l'iode orienté moléculairement ; et

une étape de nettoyage consistant à nettoyer le stratifié de film optique par une solution aqueuse d'iodure de potassium pour qu'un rapport molaire (I/K) d'iode élémentaire (I) sur potassium élémentaire (K) contenu dans le film polarisant soit de 1,8 ou plus.

11. Procédé selon la revendication 10, dans lequel la première étape d'insolubilisation consiste en une étape d'immersion du stratifié étiré dans une solution aqueuse d'acide borique.

12. Procédé selon la revendication 10 ou 11, dans lequel la seconde étape d'insolubilisation consiste en une étape d'immersion du stratifié teinté dans une solution aqueuse d'acide borique.

13. Procédé selon l'une quelconque des revendications 10 à 12, dans lequel la seconde étape d'étirement consiste en une étape d'étirement du stratifié teinté insolubilisé dans une solution aqueuse d'acide borique contenant de l'acide borique dans une quantité de 6 parties en poids ou plus pour 100 parties en poids d'eau, pour former un stratifié de film optique incluant un film polarisant composé d'une résine à base de vinylique ayant de l'iode orienté moléculairement.

14. Procédé selon l'une quelconque des revendications 10 à 13, dans lequel l'étape de nettoyage consiste en une étape de nettoyage du stratifié de film optique par une solution aqueuse d'iodure de potassium contenant de l'iodure de potassium dans une quantité de 0,5 à 2 parties en poids pour 100 parties en poids d'eau.

15. Procédé selon l'une quelconque des revendications 10 à 14, dans lequel le substrat de résine thermoplastique non cristallisable est un substrat de résine thermoplastique à base d'ester non cristallisable.

16. Procédé selon la revendication 15, dans lequel la résine thermoplastique à base d'ester non cristallisable consiste en du polytéréphtalate d'éthylène non cristallisable incluant du polytéréphtalate d'éthylène copolymérisé avec de l'acide isophtalique, du polytéréphtalate d'éthylène copolymérisé avec du cyclohexanediméthanol ou un autre polytéréphtalate d'éthylène copolymérisé, dans lequel on fait en sorte que le polytéréphtalate d'éthylène non cristallisable ait une fonction d'orientation de 0,10 ou moins, et soit soumis à un étirement dans l'air à température élevée.

17. Procédé selon l'une quelconque des revendications 10 à 16, dans lequel le substrat de résine thermoplastique non cristallisable est constitué d'une résine transparente.

18. Procédé selon l'une quelconque des revendications 10 à 17, qui comprend en outre une étape d'application d'une résine à base de vinylique sur le substrat de résine thermoplastique non cristallisable et de séchage de la résine à base de vinylique appliquée pour former une couche de résine à base de vinylique sur le substrat de résine thermoplastique non cristallisable.

19. Procédé selon l'une quelconque des revendications 10 à 18, dans lequel la première étape d'étirement est réalisée à un rapport d'étirement de 3,5 fois ou moins.

20. Procédé selon l'une quelconque des revendications 10 à 19, dans lequel la première étape d'étirement est réalisée à une température d'étirement supérieure ou égale à une température de transition vitreuse de la résine à base de vinylique.

21. Procédé selon l'une quelconque des revendications 10 à 20, dans lequel un rapport d'étirement total pour le stratifié étiré et le stratifié teinté dans les première et seconde étapes d'étirement est établi dans la plage de 5,0 à 6,5 fois.

## FIG.1

## FIG.2

| | IODINE [WEIGHT%] | POTASSIUM [WEIGHT%] | I / K (MOLE RATIO) |
|---|---|---|---|
| SAMPLE1 | 0.75 | 0.23 | 1.0 |
| SAMPLE2 | 4.33 | 1.33 | 1.0 |
| SAMPLE3 | 8.05 | 1.27 | 1.95 |
| SAMPLE4 | 11.82 | 1.23 | 2.97 |
| SAMPLE5 | 9.09 | 2.80 | 1.00 |

# FIG.3

| I /K<br>(MOLE RATIO) | IODINE | POTASSIUM | I /K<br>(INTENSITY RATIO) | CONVERSION FROM<br>(INTENSITY RATIO)TO<br>(MOLE RATIO) |
|---|---|---|---|---|
| FEED AMOUNT | kcps | kcps | MEASURED<br>VALUE | |
| 1.00 | 0.23957 | 0.47227 | 0.51 | 1.97 |
| 1.00 | 0.27757 | 0.53932 | 0.51 | 1.94 |
| 1.00 | 1.24367 | 2.38584 | 0.52 | 1.92 |
| 1.00 | 1.31448 | 2.55097 | 0.52 | 1.94 |
| 1.00 | 1.80306 | 3.4198 | 0.53 | 1.90 |
| 1.00 | 1.50769 | 2.8819 | 0.52 | 1.91 |
| 1.95 | 2.43547 | 2.40352 | 1.01 | 1.93 |
| 1.95 | 2.64294 | 2.57776 | 1.03 | 1.90 |
| 1.95 | 3.74938 | 3.6615 | 1.02 | 1.91 |
| 1.95 | 3.96641 | 3.84506 | 1.03 | 1.89 |
| 2.97 | 4.11722 | 2.63896 | 1.56 | 1.90 |
| 2.97 | 3.97466 | 2.56524 | 1.55 | 1.92 |
| 2.97 | 5.93631 | 3.75556 | 1.58 | 1.88 |
| 2.97 | 5.60321 | 3.59376 | 1.56 | 1.90 |
| 1.00 | 4.67741 | 8.70865 | 0.54 | 1.86 |
| 1.00 | 4.69356 | 8.89304 | 0.53 | 1.89 |

# FIG.4

## FIG.5

$y = 18.179x$
$R^2 = 0.9941$

ELEMENTAL IODINE CONCENTRATION [w%] vs DETECTED INTENSITY OF IODINE [kcps/$\mu$m]

## FIG.6

$y = 2.9932x$
$R^2 = 0.9901$

ELEMENTAL POTASSIUM CONCENTRATION [w%] vs DETECTED INTENSITY OF POTASSIUM [kcps/$\mu$m]

# FIG.7

| | THICKNESS OF POLARIZING FILM | TRANSMITTANCE | IODINE CONCENTRATION | I/K (RATIO OF IODINE TO POTASSIUM) | EVALUATION | | |
|---|---|---|---|---|---|---|---|
| | [μ] | [%] | [wt%] | [MOLE RATIO] | THINNESS | BRIGHTNESS | DURABILITY |
| INVENTIVE EXAMPLE 1 | 5 | 45 | 4.2 | 1.8 | GOOD | GOOD | GOOD |
| INVENTIVE EXAMPLE 2 | 5 | 45 | 3 | 2.3 | GOOD | GOOD | GOOD |
| INVENTIVE EXAMPLE 3 | 5 | 45 | 2.7 | 2.6 | GOOD | GOOD | GOOD |
| COMPARATIVE EXAMPLE | 5 | 45 | 5.1 | 1.6 | GOOD | GOOD | NG DUE TO APPEARANCE DEFECT |
| REFERENCE EXAMPL 1 | 5 | 42.8 | 8.2 | 2 | GOOD | NG DUE TO LOW TRANSMITTANCE | GOOD |
| REFERENCE EXAMPL 2 | 23 | 45 | 1.7 | 1.4 | NG DUE TO LARGE THICKNESS | GOOD | GOOD |

EP 2 837 489 B1

FIG.8

# FIG.9

EP 2 837 489 B1

EP 2 837 489 B1

## FIG.10a

200: ORGANIC EL DISPLAY DEVICE
206: PROTECTIVE LAYER
203: POLARIZING FILM
LAMINATE 205
204: FIRST RETARDATION LAYER
202: PRESSURE-SENSITIVE ADHESIVE LAYER
201: ORGANIC EL DISPLAY PANEL

## FIG.10b

200: ORGANIC EL DISPLAY DEVICE
206: PROTECTIVE LAYER
203: POLARIZING FILM
204: FIRST RETARDATION LAYER
202: PRESSURE-SENSITIVE ADHESIVE LAYER
201: ORGANIC EL DISPLAY PANEL

## FIG.10c

200: ORGANIC EL DISPLAY DEVICE
207: WINDOW
206: PROTECTIVE LAYER
203: POLARIZING FILM
204: FIRST RETARDATION LAYER
202: PRESSURE-SENSITIVE ADHESIVE LAYER
201: ORGANIC EL DISPLAY PANEL

32

# FIG.10d

200: ORGANIC EL DISPLAY DEVICE
207: WINDOW

206: PROTECTIVE LAYER
208: DIFFUSION LAYER
203: POLARIZING FILM
204: FIRST RETARDATION LAYER
202: PRESSURE-SENSITIVE ADHESIVE LAYER
201: ORGANIC EL DISPLAY PANEL

# FIG.10e

200: ORGANIC EL DISPLAY DEVICE
207: WINDOW

206: PROTECTIVE LAYER
203: POLARIZING FILM
208: DIFFUSION LAYER
204: FIRST RETARDATION LAYER
202: PRESSURE-SENSITIVE ADHESIVE LAYER
201: ORGANIC EL DISPLAY PANEL

# FIG.10f

200: ORGANIC EL DISPLAY DEVICE
207: WINDOW

206: PROTECTIVE LAYER
209: EASY-ADHESION LAYER
203: POLARIZING FILM
204: FIRST RETARDATION LAYER
202: PRESSURE-SENSITIVE ADHESIVE LAYER
201: ORGANIC EL DISPLAY PANEL

# FIG.10g

200: ORGANIC EL DISPLAY DEVICE

207: WINDOW

210: ANTISTATIC LAYER

206: PROTECTIVE LAYER

209: EASY-ADHESION LAYER

203: POLARIZING FILM

204: FIRST RETARDATION LAYER

202: PRESSURE-SENSITIVE ADHESIVE LAYER

201: ORGANIC EL DISPLAY PANEL

# FIG.10h

200: ORGANIC EL DISPLAY DEVICE

207: WINDOW

210: ANTISTATIC LAYER

211: SECOND RETARDATION LAYER

206: PROTECTIVE LAYER

209: EASY-ADHESION LAYER

203: POLARIZING FILM

204: FIRST RETARDATION LAYER

202: PRESSURE-SENSITIVE ADHESIVE LAYER

201: ORGANIC EL DISPLAY PANEL

# FIG.11

300: ORGANIC EL DISPLAY DEVICE

207: WINDOW

301: PATTERNING RETARDATION LAYER

206: PROTECTIVE LAYER

209: EASY-ADHESION LAYER

203: POLARIZING FILM

204: FIRST RETARDATION LAYER

202: PRESSURE-SENSITIVE ADHESIVE LAYER

201: ORGANIC EL DISPLAY PANEL

# FIG.12a

400: ORGANIC EL DISPLAY DEVICE

207: WINDOW

401a: PATTERNED ELECTRODE

401c: DIELECTRIC LAYER

401: TOUCH PANEL LAMINATE

401b: PATTERN ELECTRODE

210: ANTISTATIC LAYER

211: SECOND RETARDATION LAYER

206: PROTECTIVE LAYER

209: EASY-ADHESION LAYER

203: POLARIZING FILM

204: FIRST RETARDATION LAYER

202: PRESSURE-SENSITIVE ADHESIVE LAYER

201: ORGANIC EL DISPLAY PANEL

# FIG.12b

500: ORGANIC EL DISPLAY DEVICE

207: WINDOW

210: ANTISTATIC LAYER

211: SECOND RETARDATION LAYER

206: PROTECTIVE LAYER

209: EASY-ADHESION LAYER

203: POLARIZING FILM

204: FIRST RETARDATION LAYER

501: TOUCH PANEL LAMINATE

202: PRESSURE-SENSITIVE ADHESIVE LAYER

201: ORGANIC EL DISPLAY PANEL

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 4279944 B
- JP 2001343521 A
- JP 2003043257 A
- US 4659523 B
- JP 8012296 B
- JP 4691205 B
- US 4659523 A

**Non-patent literature cited in the description**

- **K. MATSUHIRO.** Xpol and its Application to 3D-TV. *EKISHO,* 2010, vol. 14 (4), 219-232